# EUROPÄISCHE PATENTSCHRIFT

(11) **EP 0 294 363 B1**
(45) Veröffentlichungstag und Bekanntmachung des Hinweises auf die Patenterteilung: **28.09.1994**
(21) Anmeldenummer: 88890133.7
(22) Anmeldetag: 01.06.1988
(51) Int. Cl.: G03B 41/00, H01J 37/317, H01J 37/304

(54) **Anordnung und Verfahren zum Positionieren der Abbildung der auf einer Maske befindlichen Struktur auf ein Substrat**
Method and device for positioning and aligning the image pattern of a mask on a substrate
Méthode et dispositif pour positionner et aligner la structure d'image d'un masque sur un substrat

(30) Priorität: 02.06.1987 AT 1404/87
(43) Veröffentlichungstag der Anmeldung: 07.12.1988
(73) Patentinhaber: IMS Ionen Mikrofabrikations Systeme Gesellschaft m.b.H., A-1020 Wien (AT); Österreichische Investitionskredit Aktiengesellschaft, 1013 Wien (AT)
(72) Erfinder: Stengl, Gerhard, Dr., A-9241 Wernberg, Kärnten (AT); Löschner, Hans, Dr., A-1190 Wien (AT); Hammel, Ernst, Dr., A-1190 Wien (AT); Glavish, Hilton F., Dr., Salem, Massachusetts 01970 (US)
(74) Vertreter: Matschnig, Franz, Dipl.-Ing.

(56) Entgegenhaltungen:
- EP-A- 0 006 985
- EP-A- 0 250 391
- EP-A- 0 325 575
- FR-A- 2 378 350
- TECHN. PROC. SEMICON/WEST, SEMI, Mountain View, CA, 1986, pages 42-52; G. STENGL et al.: "Sub-0.1-mum ion projection lithography"
- SPIE, vol. 632, Electron-Beam, X-Ray, & Ion-Beam Techniques for Submicrometer Lithographies V (1986), Seiten 146-155, B.S. Fay et al. : "Advanced X-ray alignment system"

## Beschreibung

Die Erfindung betrifft eine Anordnung für die Ionenprojektionslithographie gemäß dem Oberbegriff des Anspruchs 1. Bevorzugtes Anwendungsgebiet ist die verkleinernde oder 1 : 1 Ionenprojektionslithographie.

Durch das Dokument Techn.Proc.Semicon/West, Mountain View, Ca.1986, Seiten 42-52, G.Stengl et al: "Sub-0,1 »m Ion Projection Lithography" wurde es bekannt, Markierungen in einer Maske auf einen ebenfalls mit Markierungen versehenen Träger abzubilden und die Abbilder der Maskenmarkierungen in Koinzidenz mit den Trägermarkierungen zu bringen. Dabei werden Ionenstrahlen, welche die Markierungen der Maske durchsetzt haben, elektrostatisch über die Trägermarkierungen gescannt und die von den Trägermarkierungen ausgehenden Sekundärstrahlen Detektoren zugeführt. Für das Alignment in X, Y, Θ und dem Maßstab sind 8 Detektoren, nämlich zwei für jede Richtung zwischen der Projektionslinse und dem Träger, der hier vom Wafer gebildet ist, vorgesehen. Die Markierungen und die Detektoren sind so angeordnet, daß die Messung für jede Richtung voneinander entkoppelt sind. Über ein elektronisches Rückkopplungssystem auf den Oktopol, das Solenoid und die Projektionslinse wird der die Maskenmarkierungen durchsetzende Strahl in Übereinstimmung mit den Mittellinien der Trägermarkierungen gebracht.

Aufgabe der Erfindung ist es, etwaige Veränderungen im Abbildungssystem, insbes. auch während der Abbildung, also "on line", wie sie etwa durch Erschütterungen oder durch Drift der von Netzgeräten gelieferten Linsenspannungen entstehen können, beobachten zu können und die entsprechenden Korrekturen auszuführen. Erreicht wird dies bei einer Anordnung der eingangs erwähnten Gattung dadurch, daß gemäß der Erfindung der mit den Markierungen versehene Träger ein in vorgegebener Position relativ zum Wafer, jedoch örtlich getrennt vom Wafer, bevorzugt parallel zum Wafer, in Strahlrichtung vor dem Wafer angeordneter Referenzblock ist, der eine Öffnung aufweist, die der Größe der auf dem Wafer entstehenden Masken-Abbildung entspricht, so daß die Markierungen außerhalb des Strahlenganges der das Bild auf dem Wafer erzeugenden Ionenprojektionseinrichtung angeordnet sind, daß die Detektoren zur Aufnahme der von den Markierungen am Referenzblock emittierten Sekundärstrahlung angeordnet sind und daß die Einrichtung zur Maßstabskorrektur bei der 1 : 1 Schattenprojektion als mechanische Einrichtung zur Änderung der Höhenlage des Wafers ausgebildet ist. Durch die Anordnung des Referenzblockes wird eine Abschattung gegen die Detektion von Sekundärelektronen erreicht, welche von den auf den Wafer auftreffenden Ionenstrahlen herrühren, so daß die Detektoren keiner Beeinflussung vom Wafer her, die die Anzeige und damit die Korrektur beeinflussen könnten, unterliegen.

Um die richtige Lage des Wafers bezüglich des Referenzblockes zu erzielen, ist in weiterer Ausgestaltung der Erfindung vorgesehen, daß der Referenzblock mit weiteren Markierungen, z.B. in Form eines Strichgitters, versehen ist, und daß am Wafer mit den am Referenzblock vorgesehenen zusätzlichen Markierungen korrespondierende Markierungen vorgesehen sind, wobei zur Feststellung von Abweichungen in der Lage-Übereinstimmung der am Referenzblock und am Wafer befindlichen Markierungen, eine optische Alignmenteinrichtung vorgesehen ist. Diese optische Einrichtung kann beispielsweise so ausgebildet sein, wie dies in SPIE Vol.632 "Electron-Beam, X-Ray, & Ion Beam Techniques for Submicrometer Lithographies V (1986) S. 146-155 v. B.S.Fay et al" beschrieben ist.

In weiterer Ausgestaltung der erfindungsgemäßen Anordnung kann die zur Feststellung von Abweichungen in der Lageübereinstimmung der Strichmarkierungen vorgesehene optische Einrichtung mit einer Steuereinrichtung für die Bewegung des Tisches, auf dem der Wafer befestigt ist, gekuppelt sein, wobei Signale der optischen Einrichtung, der Steuereinrichtung für die Tischbewegung zuführbar sind.

Etwaige Verschiebungen des projizierten Bildes des Referenzstrahles können, insbes. auch während der Belichtung, beobachtet werden und entsprechende Korrekturen durch Steuerung des Multipoles sowie der Einrichtung zur Erzeugung des axialen magnetischen Feldes vorgenommen werden, um solcherart eine möglichst hohe Stabilisierung des Bildes gegenüber dem Referenzblock zu erzielen. Die Detektoren für die von den Markierungen auf dem Referenzblock ausgehenden Sekundärstrahlen können dabei in einer durch zwei teilbaren Anzahl vorgesehen sein, wobei von den Detektorpaaren jeweils zwei Paare zur Steuerung des Multipoles, ein Paar, bevorzugt im Verein mit einem der Paare für die Steuerung des Multipoles, zur Steuerung der Einrichtung zur Erzeugung eines magnetischen Drehfeldes und ein weiteres Paar zur Steuerung einer dem Referenzblock vorgeschalteten Linse (Projektionslinse) entweder im Sinne einer Vergrößerung oder Verkleinerung der Abbildung vorgesehen sind. Jedem Detektorpaar ist dabei eine geradlinige Markierung auf dem Referenzblock zugeordnet, wobei zwei der Markierungen miteinander fluchtend auf dem Referenzblock angeordnet sind, eine dritte Markierung unter einem Winkel, bevorzugt unter einem rechten Winkel zu den beiden miteinander fluchtenden Markierungen angeordnet ist und eine vierte Markierung parallel zur dritten, jedoch seitlich zu dieser versetzt auf dem Referenzblock angeordnet ist. In der Symmetrielinie zwischen den beiden fluchtend zueinander angeordneten Markierungen ist die unter einem Winkel zu diesen Markierungen liegende dritte Markierung angeordnet. Die geradlinigen Markierungen sind von einer im Querschnitt bevorzugt V-förmigen, metallischen Nut gebildet.

Die beiden jeweils einer geradlinigen Markierung zugeordneten Detektoren werden auf verschiedenen Seiten der jeweiligen Markierung außerhalb des Einflußbereiches von Teilchen, die von anderen Markierungen ausgehen, angeordnet, sodaß sichergestellt ist, daß nur Teilchen der einem Detektorpaar jeweils zugeordneten Markierung auf dem Referenzblock von diesem Detektorpaar erfaßt werden.

Die Kontrolle der Relativlage zwischen Referenzblock und Wafer kann in dieser Anordnungsvariante auf zwei Arten erfolgen:
a) Der Fehler der Lageübereinstimmung zwischen dem am Referenzblock vorgesehenen weiteren Markierungen gegenüber den ihnen zugeordneten Markierungen am Wafer wird laufend während der Belichtung detektiert und in eine solche Korrekturbewegung des Tisches umgesetzt, daß ein Unterschreiten eines Schwellenwertes des Fehlers erfolgt oder
b) die Lageübereinstimmung zwischen den am Referenzblock vorgesehenen weiteren Markierungen gegenüber den ihnen zugeordneten Markierungen am Wafer wird über das optische Alignment-System vor der Belichtung herbeigeführt. Hingegen erfolgt die Kontrolle der Waferlage gegenüber dem Referenzblock während der Belichtung in einer besonderen Ausgestaltung der erfindungsgemäßen Anordnung durch ein Interferometer, insbes. ein Laserinterferometer, wobei von dem Interferometer Stelleinrichtungen des Tisches angesteuert werden.

Dem Tisch können Stelleinrichtungen zur Verstellung in zwei zueinander senkrechten Richtungen in einer Ebene senkrecht zur optischen Achse der Ionenprojektionseinrichtung, weiters Stelleinrichtungen zum Drehen des Tisches um die optische Achse und Stelleinrichtungen für die Höhenverstellung des Tisches zugeordnet sein. Die vom Interferometer gesteuerten Korrekturbewegungen sind so gerichtet, daß die vor der Belichtung über das optische Alignmentsystem eingestellte Relativlage zwischen Referenzblock und Tisch beibehalten wird.

Zur Drehung des Tisches und damit des Bildes der Maskenstruktur um die optische Achse kann ein Drehtisch vorgesehen sein, der einen Koordinatentisch (Bewegung in X- und Y-Richtung) trägt, oder auf diesem angeordnet ist. Der Drehtisch wird durch einen Motor betätigt, der von der Steuereinrichtung für das Alignment in X- und in Y-Richtung sowie für die winkelmäßige Verstellung Θ angesteuert wird. Die Drehung des Bildes der Maskenstruktur um die optische Achse kann jedoch auch durch Drehen der Maske um die optische Achse bewerkstelligt werden. Der Antrieb der Maske erfolgt durch einen Motor über ein Getriebe, wobei der Motor von der Steuereinrichtung für das Alignment in X- und Y-Richtung sowie für die winkelmäßige Verstellung Θ angesteuert wird.

Eine weitere erfindungsgemäße Ausführungsvariante ist dadurch gekennzeichnet, daß die optische Einrichtung zur Feststellung von Abweichungen in der Lageübereinstimmung der Strichmarkierungen nicht mit den Stelleinrichtungen für den Tisch, sondern mit der Steuereinrichtung für den Multipol und das axiale Magnetfeld gekuppelt ist. Diese Anordnung erlaubt eine Beeinflussung des ionenoptischen Strahlenganges abhängig von der Abweichung der Lageübereinstimmung der Strichmarkierungen am Referenzblock und am Wafer. In dieser Ausführungsvariante wird so verfahren, daß der Tisch in eine Lage gebracht wird, in der die Markierungen auf dem Wafer lediglich um weniger als ein vorgegebenes Maß, z.B. um weniger als 1 »m, von der Sollage gegenüber den ihnen zugeordneten, weiteren Markierungen des Referenzblockes abweichen (Grob-Alignment), wonach das Interferometer aktiviert wird, d.h. auf die Verstelleinrichtung des Tisches wirkt und zumindest bis zur Beendigung der Belichtung in aktivem Zustand gehalten wird und daß nach Aktivierung des Interferometers, aber noch vor der Belichtung, die mit dem optischen Alignmentsystem festgestellten Abweichungen in der Lageübereinstimmung der am Referenzblock vorgesehenen weiteren Markierungen gegenüber den ihnen zugeordneten Markierungen am Wafer, ionenoptisch korrigiert werden, und zwar entsprechend einem (funktionell) vorgegebenen Zusammenhang zwischen der optisch festgestellten Abweichung und den Einwirkgrößen auf die Ionenprojektionseinrichtung zur Korrektur dieser Abweichung, wonach dann die Belichtung erfolgt. Bei dieser Verfahrensvariante erfolgt zunächst eine Grobausrichtung des Tisches auf die gewünschte Chip-Position gegenüber dem Referenzblock, wonach durch Aktivieren des Interferometers die Tischposition gegenüber dem Referenzblock gehalten wird und die optisch festgestellte Abweichung zwischen Chip und Referenzblock ionenoptisch korrigiert wird. Wesentlich ist dabei, daß der funktionelle Zusammenhang (Eichkurve) zwischen der optisch festgestellten Abweichung und die zu deren Korrektur notwendige Einwirkung auf die Ionenprojektionseinrichtung (Beaufschlagung des Multipols zur Korrektur des Strahles in x- und y-Richtung, Größe des axialen Magnetfeldes, und Spannung an der Projektionslinse) festgelegt ist. Nach der erfolgten Belichtung werden die Detektoren für die Sekundärstrahlung wieder aktiviert, wodurch die Markierungen der Maske wieder in Übereinstimmung mit den Markierungen auf dem Referenzblock gebracht werden, wobei zur Erlangung einer neuen Tischposition gegenüber dem Referenzblock zwecks Belichtung eines weiteren Chip das Interferometer in den inaktiven Zustand versetzt wird.

Bei längeren Belichtungszeiten kann die Belichtung eines Chips jedoch auch in Stufen erfolgen, d.h. daß einer Belichtung mindestens eine weitere Belichtung folgt, um ein und denselben Chip unter Verwendung derselben Maske in mindestens einer weiteren Stufe zu belichten, wobei zwischen zwei aufeinanderfolgenden Belichtungen wieder die Strahllage gegenüber dem Referenzblock korrigiert wird. Es wird dabei so vorgegangen, daß zwischen zwei aufeinanderfolgenden Belichtungen zunächst die Abbildung der Markierungen der Maske über die Sekundärstrahlungsdetektoren wieder auf die Markierungen des Referenzblockes ausgerichtet werden, wonach die Detektoren in den inaktiven Zustand versetzt werden und die ionenoptische Einrichtung nunmehr abhängig von der optisch festgestellten Abweichung der zusätzlichen Markierungen des Referenzblockes von den zugeordneten Markierungen am Wafer korrigiert wird, wonach eine weitere Belichtung erfolgt.

Zur Steigerung der Genauigkeit kann jedoch auch während der Belichtung - entsprechend der Eichkurve - die ionenoptische Korrektur "on line" mit der optisch festgestellten Abweichung der zusätzlichen Markierungen auf dem Referenzblock von den Markierungen auf dem Wafer, erfolgen.

Nach einer dritten Vorgangsweise wird während des Chip-Belichtungsvorganges sowohl die Stabilisierung des Bildes der Maske gegenüber dem Referenzblock (mittels der Detektoren) aufrecht erhalten, als auch die Tischlage gegenüber dem Referenzblock kontrolliert und für Abweichungen derselben kompensiert. Dies wird in einer weiteren Ausgestaltung der Erfindung dadurch bewerkstelligt, daß ausschließlich die durch die Maskenmarkierungen hindurchtretenden Strahlen dem Einfluß eines zeitlich veränderbaren Feldes unterworfen und dadurch über einen, die den Markierungen der Maske zugeordneten Markierungen enthaltenden Bereich des Referenzblockes, bevorzugt mit konstanter Geschwindigkeit, hin- und herbewegt werden, wobei beim Überstreichen einer Markierung, z.B. Grube, der Detektor ein maximales Signal liefert, dem ein bestimmter Augenblickswert der zeitlich sich ändernden Ablenkspannung für die Referenzstrahlen zugeordnet ist, daß dieser Augenblickswert mit einem Sollspannungswert verglichen wird, der dem maximalen Detektorsignal bei stabilisiertem, d.h. sich gegenüber dem Referenzblock nicht bewegenden, Bild der Maskenstruktur, entspricht, und daß der Unterschied zwischen dem Augenblickswert der Ablenkspannung und dem Sollspannungswert durch Beeinflussung des ionenoptischen Abbildungssystems kompensiert wird. Zur Durchführung dieses Verfahrens sind in der erfindungsgemäßen Anlage weitere Ablenkeinheiten, z.B. Oktopole, geschaltet als elektrische Dipole, nur für die durch die Maskenmarkierungen hindurchtretenden Strahlen vorgesehen. Diese zusätzlichen Ablenkeinheiten wirken nicht auf die von den eigentlichen Maskenstrukturen herrührenden Strahlen. Die Ablenkung der durch die Maskenmarkierungen hindurchtretenden Strahlen (das "Wobbeln") kann z.B. mit einer sägezahnförmigen Spannung erreicht werden, welche an den als elektrische Dipole geschalteten Oktopolen, anliegt. Wenn die Ablenkgeschwindigkeit nicht konstant ist, so muß ihre zeitliche Abhängigkeit auf jeden Fall genau bekannt sein.

Ist nun das Bild gegenüber dem Referenzblock stabil, so erhält man von einer Referenzmarke auf dem Referenzblock immer dann ein maximales Signal, wenn die zeitlich veränderliche Spannung an dem entsprechenden "Referenz-Oktopol" einen bestimmten fixen Wert, Uo, erreicht. Umgekehrt deutet eine Veränderung des Spannungswertes um ΔUo, bei der das maximale Referenzmarken-Signal auftritt, auf ein Abdriften des Referenzstrahles, also des eigentlichen Bildes und der Referenzstrahlen, um z.B. eine Strecke Δx hin. Wegen des gegebenen und genau bekannten Zusammenhanges zwischen Ablenkspannung und Ablenkzeit (z.B. bei konstanter Geschwindigkeit) und anderseits zwischen Ablenkspannung und Ablenkstrecke, kann das Abdriften des Strahles entweder über eine Zeitmessung oder eine Spannungsmessung festgestellt werden. Die Bildstabilisierung erfolgt demnach mit Hilfe der ionenoptischen Korrektureinheiten (Multipol, axiales Magnetfeld, Spannungsänderung der Projektionslinse) so, daß das von den Referenzmarken herrührende Detektorsignal immer bei derselben Referenz-Oktopol-Spannung Uo bzw. immer nach demselben Zeitintervall Δto, maximal ist.

Zusätzlich werden jedoch auch mit Hilfe des optischen Alignments Abweichungen der Tischlage gegenüber dem Referenzblock korrigiert, wobei aber die Strahllage gegenüber dem Referenzblock immer noch unter Kontrolle bleibt. Hierbei wird ein vom optischen Alignment kommendes Signal, welches eine Änderung der Tischlage gegenüber dem Referenzblock anzeigt, wie bereits beschrieben, in ein Signal für die ionenoptische Korrektureinheit transformiert, welches das Bild der Maskenstrukturen wieder in Koinzidenz mit den entsprechenden Strukturen auf dem Chip bringt. Dies bewirkt natürlich auch eine Verschiebung der Referenzstrahlen und damit eine Änderung der Spannung Uo, an die die Anspeisung der ionenoptischen Korrektureinheit gekoppelt ist, um das Bild gegenüber dem Referenzblock stabil zu halten. Da der neue Wert Uo jedoch in eindeutigem Zusammenhang mit dem vom optischen Alignment kommenden Signal steht, wird die Bildstabilisierung nun computergesteuert auf diesen neuen Wert eingeregelt.

Um verhindern zu können, daß zu einem unerwünschten Zeitpunkt Ionenstrahlen auf den Tisch bzw. den darauf befindlichen Wafer gelangen, können Shutter verschiedener Art (elektronische oder mechanische Shutter) in verschiedener Anordnung in der Ionenprojektionseinrichtung und in verschiedener Ausbildung vorgesehen werden.

Alle vorstehend beschriebenen Alignmentmaßnahmen eignen sich für die 1 : 1 Ionenprojektionslithographie oder für die verkleinernde Ionenprojektionslithographie.

Die Erfindung wird nachstehend anhand der Zeichnung näher erläutert. Es zeigen,

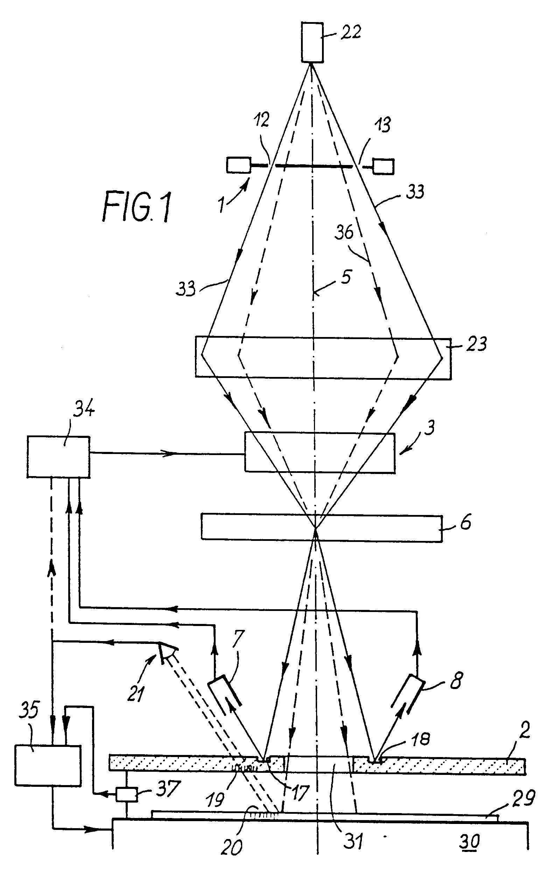

Fig. 1 eine erste Ausführungsform einer erfindungsgemäßen Anlage, stark schematisiert,
Fig. 2 eine gegenüber Fig. 1 modifizierte Anlage,
Fig. 3 schematisch ein Detail aus Fig. 2, wobei zur Erläuterung die Spannung, welche die Ablenkeinrichtung des Referenzstrahles steuert, als Funktion der Zeit und die Auslenkung des Referenzstrahles ebenfalls als Funktion der Zeit eingetragen ist,
Fig. 4 ein Blockschaltbild,
Fig. 5 ein Detail aus Fig. 1 zur Veranschaulichung der Mittel, mit welchen Markierungen der Maske in Übereinstimmung mit korrespondierend am Referenzblock vorgesehenen Markierungen gebracht werden können,
Fig. 6 schematisch eine Meßanordnung zur Aufnahme der Sekundärstrahlung eines auf eine Markierung des Referenzblockes gerichteten Strahlenbündels,
Fig. 7 ein Schaubild, das die Abhängigkeit der von den Detektoren, die der Markierung auf dem Referenzblock zugeordnet sind, erfaßten Spannungen zeigt,
Fig. 8 ein Diagramm, welches die Spannungsdifferenzen zeigt, die
Fig. 9 bis 12 in übertrieben vergrößerter Darstellung verschiedene Lagen zwischen der Markierung auf dem Referenzblock und der Projektion der Markierungen der Maske,
Fig. 13 ein Blockschaltbild, aus dem die Mittel zur Steuerung der Ionenstrahlen ersichtlich sind,
Fig. 14 ein Beispiel für die Ansteuerung der Pole eines Multipoles,
Fig. 15 eine Anordnung der Detektoren über dem Referenzblock,
Fig. 16 eine gegenüber Fig. 1 abgeänderte Variante mit einer mechanischen Einrichtung zum Drehen des Bildes der Maskenstruktur,
Fig. 17 eine gegenüber Fig. 16 abgeänderte Ausführung mit einer ebenfalls mechanischen Einrichtung zum Drehen des Bildes der Maskenstruktur auf dem Wafer,
Fig. 18 eine weitere Ausführungsform mit einer mechanischen Einrichtung zum Drehen des Bildes der Maskenstruktur,
Fig. 19 zeigt einen Längsschnitt durch eine weitere Ausführungsform einer Ionenprojektionslithographieeinrichtung,
Fig. 20 in größerem Maßstab ein Detail aus Fig. 19,
Fig. 21 in ebenfalls vergrößertem Maßstab einen Strahlscanner für Alignmentzwecke und ein Detektorensystem, wie dieses in Fig. 19 dargestellt ist,
Fig. 22 schematisch in schaubildlicher Darstellung den Eintritt eines Ionenstrahles in einen Mutipol gemäß Fig. 19,
Fig. 23 ein Blockdiagramm, das schematisch die elektrische Versorgung der Maschine gemäß Fig. 19 zeigt, und
Fig. 24 ein Blockdiagramm für den Alignmentvorgang, wie er mit einer Einrichtung gemäß Fig. 19 ausgeführt werden kann.

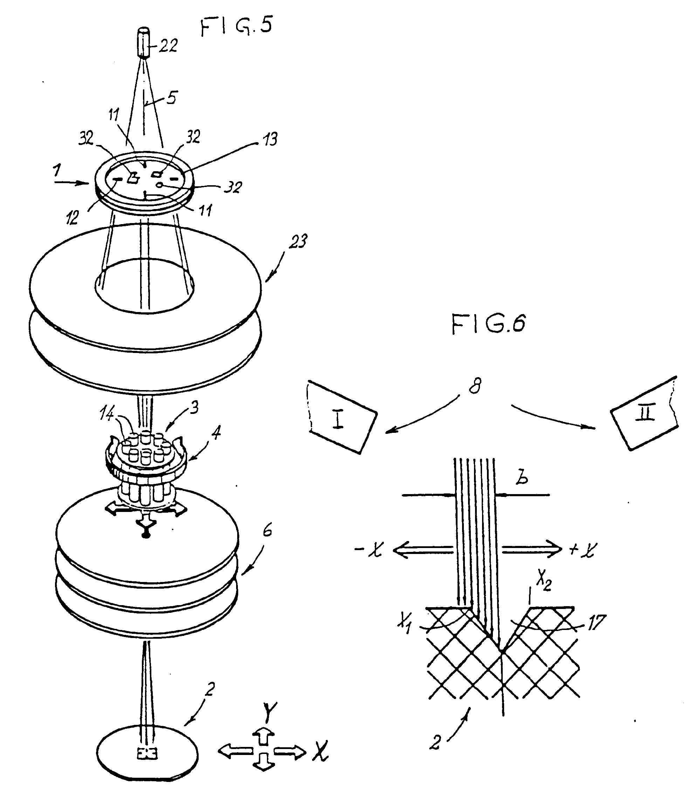

Die Erfindung wird nachstehend anhand der Zeichnung für den Fall der verkleinernden Ionenprojektion beispielsweise näher erläutert. In der Zeichnung ist mit 1 eine Maske bezeichnet, die im Strahlengang von aus einer Ionenquelle 22 kommenden Strahlen angeordnet ist. Die Maske 1 ist mit einer Struktur 32 versehen (Fig. 5), welche mittels der Ionenprojektionseinrichtung auf ein Substrat 29 abzubilden ist. Die Abbildung der Maskenstruktur 32 auf das Substrat 29 hat dabei so zu erfolgen, daß eine vorbestimmte Relativlage zwischen dem Bild der Markenstruktur 32 und einem auf dem Substrat 29 bereits vorhandenen Bild erzielt wird. Die Maske 1 ist mit Markierungen 11 - 13 versehen (die in der zeichnerischen Darstellung übertrieben groß dargestellt sind). Diese Markierungen 11 - 13 werden auf einem ebenfalls mit Markierungen 16 - 18 versehenen Träger, der als Referenzblock 2 dient, abgebildet, Die Abbildungen der Markierungen 11 - 13 der Maske 1 auf dem Referenzblock 2 werden in Koinzidenz mit den auf dem Referenzblock 2 vorhandenen, jeweils korrespondierenden Markierungen 16 - 18 gebracht.

Im Strahlengang zwischen der Maske 1 und dem Referenzblock 2 ist ein elektrostatischer, durch eine Steuereinrichtung 34 beeinflußbarer Multi- insbes. Oktopol 3 sowie eine Einrichtung 4 zur Erzeugung eines axialen magnetischen Feldes um die optische Achse angeordnet. Der Referenzblock 2 ist im dargestellten Ausführungsbeispiel parallel zum Substrat (Wafer) 29 angeordnet. Der Referenzblock 2 weist eine Öffnung 31 auf. Die Größe dieser Öffnung 31 ist entsprechend der auf dem Wafer (Substrat) 29 entstehenden Abbildung der Struktur auf der Maske 1 ausgeführt. Solcherart liegen die Markierungen 16 - 18 am Referenzblock 2 außerhalb des Strahlenganges 36 der das Bild auf dem Wafer 29 erzeugenden Ionenprojektionseinrichtung.

Für die von den Markierungen 16 - 18 am Referenzblock 2 ausgehende Sekundärstrahlung sind Detektoren 7 - 10 vorgesehen, deren Anordnung und Funktion nachstehen noch näher erläutert wird. Die Sekundärstrahlung rührt von den durch die Maskenmarkierungen 11 - 13 hindurchtretenden, auf dem Referenzblock 2 aufgetroffenen Referenzstrahlen 33 her. Die Signale der Detektoren 7 - 10 sind der Steuereinrichtung 34 für den Multi- insbes. Oktopol 3 und das axiale Magnetfeld zuführbar. Die Anordnung des Referenzblockes 2 bringt den Vorteil, daß eine Abschattung des Strahles erreicht wird und damit eine Beeinflussung der Detektoren 7 - 10 durch von unten (vom Substrat 29 her) kommende Strahlen ausgeschlossen wird.

Der Referenzblock 2 ist mit weiteren Markierungen 19 versehen, die beispielsweise als Strichgitter ausgebildet sein können. Am Wafer 29 befinden sich mit der Markierung 19 korrespondierende Markierungen 20, beispielsweise ebenfalls in Form eines Strichgitters. Um festzustellen, ob Abweichungen in der Lageübereinstimmung von den am Referenzblock 2 und am Wafer 29 befindlichen Markierungen 19 und 20 bestehen, ist eine optische Einrichtung 21 vorgesehen. Sobald Abweichungen in der Lageübereinstimmung festgestellt sind, können Schritte zur Korrektur dieser Lageabweichung eingeleitet werden. So kann etwa in einer Ausführungsform, die optische Einrichtung 21 mit einer Steuereinrichtung 35 für die Bewegung des Tisches 30, auf dem der Wafer 29 befestigt ist, gekuppelt sein. Signale der optischen Einrichtung 21 werden dann der Steuereinrichtung 35 für die Tischbewegung zugeführt. Bei dem Tisch kann es sich um einen Koordinatentisch handeln, der in zwei zueinander senkrechten Richtungen bewegt werden kann. Die Steuereinrichtung 35 steuert dann die Motoren für die Bewegung des Tisches 30 an.

Die optische Einrichtung 21 kann jedoch auch mit einer Steuereinrichtung 34 für den Multipol 3 und das axiale Magnetfeld gekuppelt sein. In diesem Fall wird abhängig von der Größe des Fehlers in der Lageübereinstimmung der Strichmarkierungen 19 mit den Strichmarkierungen 20 die Lage des Projektionsstrahles 36 und auch die Lage des Referenzstrahles 33 geändert.

Ein Interferometer 37 kann zwischen dem Referenzblock 2 und dem Tisch 30 angeordnet werden. Dieses Interferometer liefert bei Auftreten einer Relativbewegung des Tisches 30 gegenüber dem Referenzblock 2 Signale an die Steuereinrichtung 35 für die Tischbewegung zwecks Rückstellung des Tisches 30.

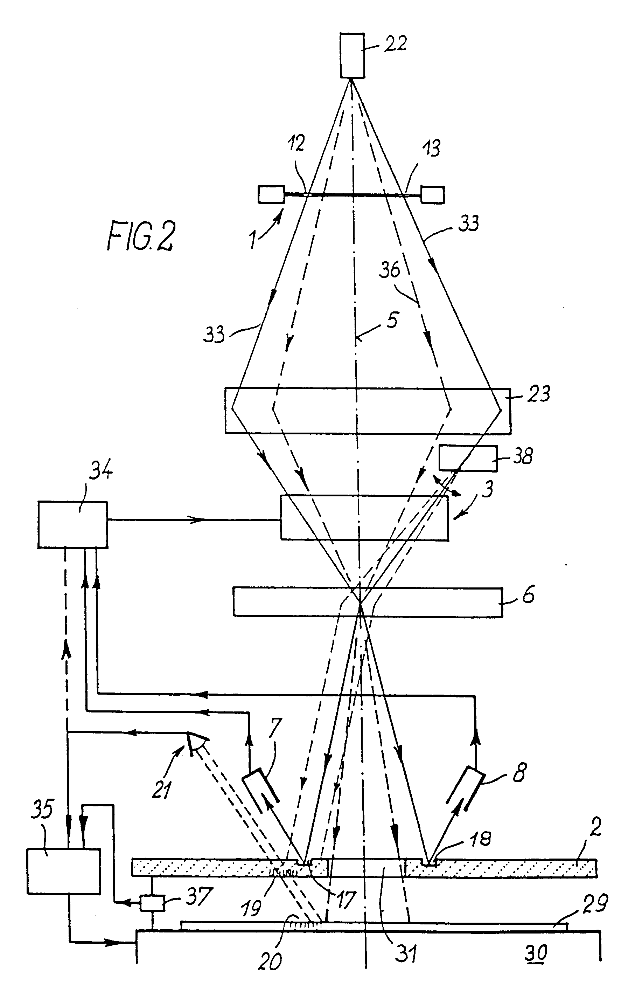

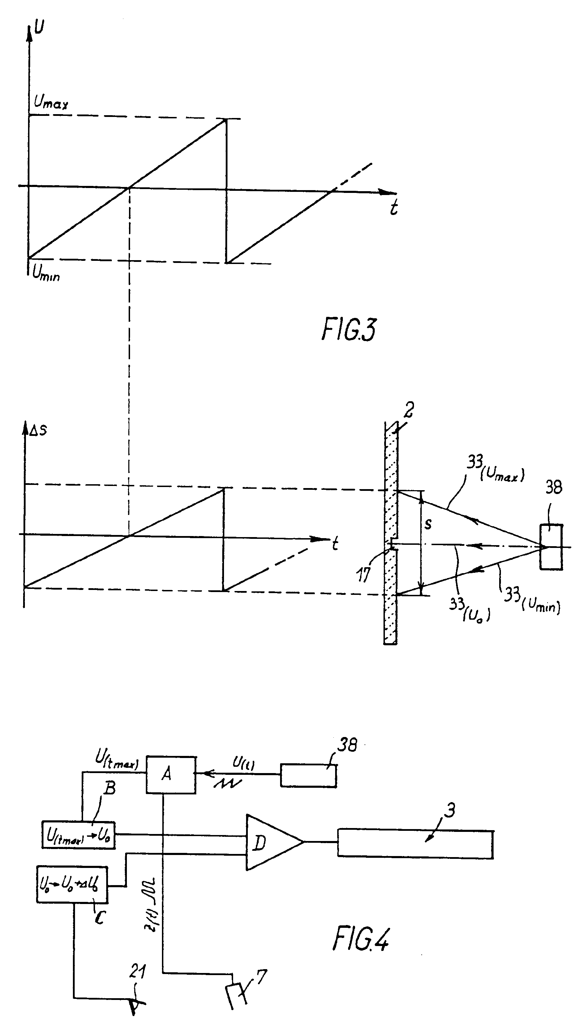

Im Strahlengang ausschließlich der Referenzstrahlen 33 sind bei der Einrichtung gemäß Fig. 2 Ablenkeinheiten 38, z.B. Oktopole, die als elektrisches Dipolfeld geschaltet sind, angeordnet. Mit dieser Anordnung ist es möglich, auch während des "on line" -Alignments mittels Bildverschiebung, Änderungen in den ionenoptischen Abbildungseigenschaften, also z.B. ein Abdriften des Bildes bedingt durch Spannungsschwankungen, z.B. an der Beschleunigungslinie, kompensieren zu können. Hiebei werden die Referenzstrahlen 33 während des Alignment- und Belichtungsvorganges dauernd über die Marken 16 - 18 des Referenzblockes 2 gewobbelt, z.B. durch Anlegen einer Sägezahnspannung an die Ablenkeinheiten 38. Die Strahlen 36, die das eigentliche Bild der Maskenstrukturen 32 erzeugen, werden durch die Ablenkeinheiten 38 nicht beeinflußt. Für den Fall, daß an einer Ablenkeinheit 38 eine Sägezahnspannung anliegt, zeigt Fig. 3 die - idealisierten - Verhältnisse, die auftreten, wenn der Wafer-Tisch 30 genau zum Referenzblock 2 ausgerichtet ist, die optische Einrichtung 21 also kein Signal liefert. Bei der Sollspannung Uo, deren Wert hier als O angenommen wird, liegt der Referenzstrahl 33 genau auf der zugeordneten Referenzmarke des Referenzblocks 2. Die vom Referenzstrahl überstrichene Strecke s wird durch die Differenz zwischen Maximal- und Minimalspannung Umax - Umin bestimmt.

In Fig. 4 ist ein beispielsweise Blockschaltbild dargestellt, das zeigt, wie die ionenoptischen Korrekturelemente 3 bzw. 4 sowohl über die Detektoren 7 - 10, von welchen nur der Detektor 7 dargestellt ist, bei den Referenzmarken 16 - 18 (zur Stabilisierung der Ionenoptik) als auch über die optische Einrichtung 21 (zur Korrektur von Verschiebungen des Wafers 29 gegenüber dem Referenzblock 2) angesteuert werden. Die Einheit A mißt dabei immer dann, wenn die vom Detektor 7 gelieferte, zur Zählrate proportionale Spannung, maximal ist, die am Oktopol 38 anliegende Spannung und führt diese Spannung U(Zmax) der Einheit B zu. Diese Einheit vergleicht U(Zmax) mit der Sollspannung Uo, das ist jene Spannung am Oktopol 38, bei der der Referenzstrahl 33 bei ideal ausgerichtetem Tisch 30 die zugeordnete Referenzmarke am Referenzblock 6 überstreichen sollte. Die gemessene Differenz wird in ein entsprechendes Signal für die ionenoptischen Korrekturelemente 3 umgewandelt, sodaß die Überstreichung der Referenzmarke wieder bei der Sollspannung Uo erfolgt. Wenn nun die optische Einrichtung 21 eine Verschiebung des Wafers 29 gegenüber dem Referenzblock 2 mißt, so wird ein entsprechendes Signal an die Einheit C übertragen, welche diese in ionenoptische Korrektursignale umwandelt, mit denen der gesamte Ionenstrahl, also auch der von den Referenzstrahlen 33 gebildete Anteil, abgelenkt bzw. gedreht werden. Der Referenzstrahl 33 überstreicht also jetzt nicht bei Uo die zugeordnete Referenzmarke, sondern bei Uo+ΔUo, wobei ΔUo eindeutig von der optischen Einrichtung 21 bestimmt wird. Die von B und herrührenden Signale werden in der Einheit D addiert und den Korrekturelementen 6 für den Ionenstrahl zugeführt.

Durch Beeinflussung des Ionenstrahles werden die Markierungen 11 - 13 der Maske 1 (Fig. 5) in Koinzidenz mit den auf dem Referenzblock 2 vorhandenen, jeweils korrespondierenden Markierungen 16 bis 18 gebracht. Die Einrichtung zur Beeinflussung des Ionenstrahles weist - wie Fig. 5 im Detail zeigt - im Strahlengang zwischen Maske 1 und dem Referenzblock 2 einen elektrostatischen Multipol 3 auf. Dieser Multipol ist im dargestellten Ausführungsbeispiel als Oktopol wiedergegeben. Weiters befindet sich im Strahlengang eine Einrichtung 4 zur Erzeugung eines magnetischen Drehfeldes um die optische Achse 5 und weiters eine Projektionslinse 6, die hinsichtlich der angelegten Spannung steuerbar ist, sodaß der Abbildungsmaßstab durch Ändern der an die Projektionslinse 6 angelegten Spannung geändert werden kann. Zwischen der Maske 1 und dem Multipol 3 befindet sich weiters eine Immersionslinse 23.

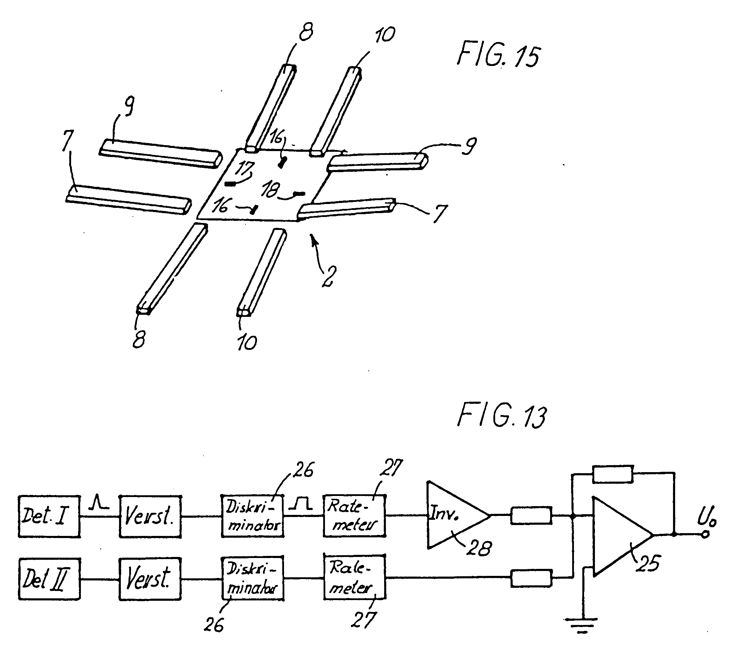

Wie Fig. 15 mehr im Detail zeigt, sind Detektoren 7 bis 10 vorgesehen, die bei Projektion der Markierungen 11 - 13 der Maske 1 auf den Referenzblock 2 eine Spannung liefern, die der von den Markierungen 16 - 18 des Referenzblockes 2 ausgehenden Sekundärstrahlung entspricht. Die Detektoren sind dabei in einer durch zwei teilbaren Anzahl vorgesehen. Im dargestellten Ausführungsbeispiel sind insgesamt acht Detektoren für die Sekundärstrahlung vorgesehen, zwei Paare 7, 8 dienen zur Steuerung des Multipoles 3, ein Paar 9 kann die Einrichtung 4 zur Erzeugung des magnetischen Drehfeldes steuern, vorzuziehen ist es jedoch, wenn das Paar 9 im Verein mit einem Paar 8 von den für die Steuerung des Multipoles 3 vorgesehenen Paaren 7, 8 die Einrichtung 4 für die Erzeugung des magnetischen Drehfeldes steuert. Das Detektorenpaar 10 steuert die der Projektionslinse 6 zugeführte Spannung, so daß je nach Änderung dieser Spannung eine Vergrößerung oder Verkleinerung der Abbildung der Strukturen von der Maske 1 auf den Referenzblock 2 erfolgen kann.

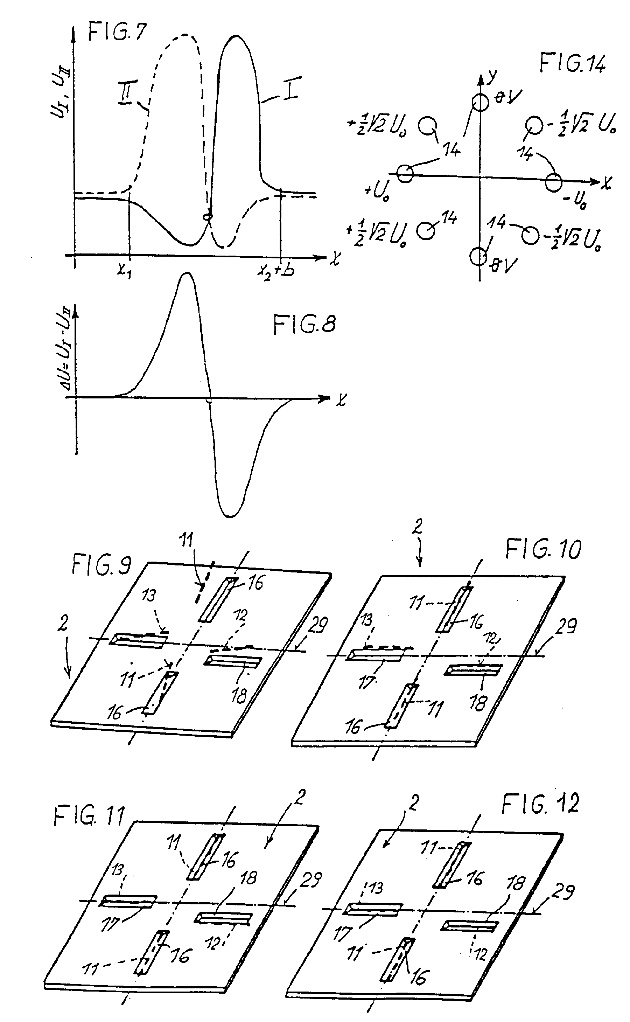

Durch entsprechende Steuerung des Multipoles 3 ist es möglich, den Strahl in X- bzw. Y-Richtung abzulenken (Fig.5). Die Detektoren können handelsübliche Elektronenvervielfacherkanäle, welche abhängig von den erfaßten Elektronen mittels der nachgeschalteten Elektronik(Fig.13) die Steuerspannung Uₒ erzeugen. Jedem Detektorpaar 7 bis 10 ist eine geradlinige Markierung 16 bis 18 auf dem Referenzblock 2 zugeordnet.Die Zuordnung ist dabei so getroffen, daß zwei geradlinige Markierungen 16 miteinander fluchtend auf dem Referenzblock 2 angeordnet sind, eine dritte geradlinige Markierung 17 ist unter rechtem Winkel zu den beiden miteinander fluchtenden Markierungen 16 angeordnet, und schließlich ist eine vierte geradlinige Markierung 18 parallel zur dritten Markierung 17, jedoch seitlich zu dieser versetzt, auf dem Referenzblock 2 angeordnet. Die Markierung 17 liegt in der Symmetrielinie 29 zwischen den miteinander fluchtenden Markierungen 16, so daß bei Nichtübereinstimmung der außerhalb der Symmetrielinie 29 liegenden Markierung 18 mit dem zugeordneten Bild der Markierung 13 der Maske 1 durch bloße Maßstabsänderung der Abbildung die Übereinstimmung erzielt werden kann (Fig. 11, 12).

Die Anordnung der Markierungen 16 - 18 auf dem Referenzblock 2 lassen besonders deutlich die Fig. 9 bis 12 bzw. 15 erkennen. Die geradlinigen Markierungen 16 - 18 auf dem Referenzblock 2 sind im dargestellten Ausführungsbeispiel als Nut mit V-Querschnitt ausgebildet.

Aus Fig. 6 im Verein mit den Fig. 7 und 8 sind die Vorgänge ersichtlich, die auftreten, wenn ein Strahl über eine als V-förmige Nut ausgebildete Markierung 16 in Richtung X geführt wird. Die Breite b des Strahles kann dabei etwa 1 »m betragen. Die Bewegung des Strahles in X-Richtung sei als durch elektrostatische Beeinflussung des Strahles verursacht angesehen. Mit I und II sind dabei in Fig. 6 die Detektoren des Detektorenpaares 8 bezeichnet. An der Stelle X₁ beginnt bei einer Verschiebung des Strahles in positiver X-Richtung die Wirkung der Markierung 17 und endet an der Stelle X₂+b.

Die im Zuge der Verschiebung des Ionenstrahles von den Detektoren I und II erzeugten Spannungen, die ein Maß für die von den Detektoren aufgenommene Sekundärstrahlung sind, sind in Fig.7 ersichtlich, bzw. ist dabei der Spannungsverlauf für den Detektor II in einem unterbrochenen Linienzug eingetragen, und der Spannungsverlauf für den Detektor I in einem durchgehenden Linienzug.

Die Differenz ΔU der Spannungen U_{I} und U_{II} ist aus Fig. 8 ersichtlich.

Aus Fig. 13 ist ersichtlich, wie die von den beiden Detektoren, die einer Markierung, z.B. der Markierung 16 in Fig. 15, zugeordnet sind, gebildeten Spannungssignale in die Steuerspannung Uₒ, z.B. für eine Ablenkung in X-Richtung, umgewandelt werden. Die von den Detektoren abgegebenen Impulse werden verstärkt, durch die Diskriminatoren 26 in Rechtecksimpulse verwandelt, sodann im Ratemeter 27 (z.B. ein Integrator) zu einer zur Impulsrate proportionalen Spannung integriert. Der Inverter 28 kehrt die auf diese Weise entstehende Spannung, die von dem einen Detektor (Detektor I) herrührt, in ihren Negativwert um, sodaß der Operationsverstärker 25 mit der Differenz der von den beiden Detektoren I, II gelieferten Spannungen angesteuert wird. Die vom Operationsverstärker 25 gelieferte Spannung Uₒ wird, entsprechend den Markierungen, von denen das Signal ausgeht, zur Steuerung des Multipols 3 zur Erzeugung des magnetischen Drehfeldes oder zur Steuerung der Projektionslinse 6 verwendet.

Fig. 14 zeigt als Beispiel, wie die Spannung Uₒ an einen Oktopol angelegt wird, damit dieser eine Ablenkung in X-Richtung hervorruft. Da im allgemeinen gleichzeitig auch in Y-Richtung abgelenkt werden soll, nämlich immer dann, wenn gleichzeitig die der entsprechenden Markierung (17 in Fig. 15 und Fig. 9 - 12) zugeordneten Detektoren ein Signal U_{y} liefern, müssen die beiden Spannungen Uₒ und U_{y} noch über eine geeignete Schaltung vektoriell addiert werden. Die entstehenden Summenspannungen werden den entsprechenden Polen des Oktopols zugeführt.

Analog zu Fig. 14 wird die vom Operationsverstärker 25 gelieferte Spannung Uₒ zur Erzeugung eines Stromes in der Spule 4, welche die Rotation des Projektionsbildes bewirkt, und zur Steuerung der Projektionslinse 6, mit der die Maßstabskorrektur vorgenommen wird, verwendet.

Aus den Fig. 9 bis 12 ist dabei ersichtlich, in welcher Weise die Einrichtung der Projektionen der auf der Maske 1 vorgesehenen Markierungen 11 bis 13 auf die Markierungen 16 bis 18 des Referenzblockes 2 erfolgt, bzw. sind dabei jeweils die Projektionen der Markierungen auf der Maske 1 mit unterbrochenen Linien dargestellt und so bezeichnet, wie die zugehörigen Schlitze auf der Maske 1, wobei die Schlitze der Maske 1 nicht unbedingt als jeweils ein einziger Schlitz ausgebildet sein müssen, sondern ein Schlitz auch durch mehrere, miteinander fluchtende Durchbrechungen der Maske 1 ausgebildet sein kann, sodaß dann eine Abbildung entsteht, wie sie in den Fig. 9 bis 12 mit 11 bis 13 bezeichnet ist.

Fig. 9 veranschaulicht dabei die gegenseitige Lage der Markierungen 16 bis 18 auf dem Referenzblock 2 und der Abbildungen 11 bis 13 der Markierungen auf der Maske 1, nachdem eine Justierung in X-Richtung erfolgt ist.

Fig. 10 gibt dann die Lage wieder, wie sie sich einstellt nach einer Drehung des projizierten Bildes der Maskenstruktur. Es ist dabei ersichtlich, daß die Bilder der Markierungen 11 der Maske 1 mit dem Scheitel der V-förmigen Markierungen 16 des Referenzblockes 2 zusammenfallen. Erfolgt nunmehr eine Verschiebung des projizierten Bildes der Maskenstruktur in Y-Richtung, so ist ersichtlich, daß von dieser Verschiebung die den Markierungen 16 des Substrates zugeordneten Detektoren unbeeinflußt bleiben, d.h. die Bewegungen des Bildes in den einzelnen Richtungen sind voneinander entkoppelt.

Fig. 11 zeigt dann die Lage nach der in Y-Richtung erfolgten Justierung. Die Abbildung der Markierung 13 des Referenzblockes 2 kommt dabei in den Scheitel der V-förmigen Nut 17 des Referenzblockes 2 zu liegen. Die einzige Markierung, die im allgemeinen nicht mit dem entsprechenden Bild einer Markierung der Maske 1 zusammenfällt, ist dabei die Markierung 18, die parallel zur Markierung 17, jedoch gegenüber dieser seitlich aus der Symmetrielinie 29 verschoben , angeordnet ist.

Um nun auch die Abbildung der Markierung 12 der Maske 1 in den Scheitel der Markierung 18 auf dem Referenzblock 2 zu bringen, ist eine Maßstabsänderung erforderlich, die durch Verändern der Spannung, die an der Projektionslinse 6 anliegt, erfolgt.

Die Stellung nach erfolgter Maßstabsänderung ist aus Fig. 12 ersichtlich. Die Fig. 12 läßt erkennen, daß nachdem zuvor bereits eine Justierung in X- und Y-Richtung sowie eine Drehung und Maßstabsänderung stattgefunden hat, nunmehr die Abbildung der Markierungen 11 bis 13 der Maske 1 auf dem Referenzblock 2 mit den dort befindlichen geradlinigen Markierungen 16 bis 18 zusammenfällt, d.h. das projizierte Ionenbild der Maske 1 ist richtig auf den Referenzblock ausgerichtet. Die vorstehend aus Gründen der Deutlichkeit als aufeinanderfolgend beschriebenen Justierschritte erfolgen zweckmäßig jedoch gleichzeitig, da es sich um entkoppelte Regelkreise handelt.

Die beiden jeweils einer geradlinigen Markierung 16 bis 18 auf dem Referenzblock 2 zugeordneten Detektoren 7 bis 10 liegen auf verschiedenen Seiten der jeweiligen Markierung, wobei sichergestellt ist, daß nur Teilchen der zugeordneten Markierung erfaßt werden.

Sobald die Ausrichtung der Markierungen 11 - 13 der Maske 1 auf die Markierungen 16 - 18 des Referenzblockes 2 beendet ist, d.h. eine Stellung, die der Fig. 12 der Zeichnung entspricht, erreicht ist, kann durch eine "Hold"-Schaltung der Strom und die Spannung festgehalten werden, wodurch die erreichte Lage stabilisiert wird.

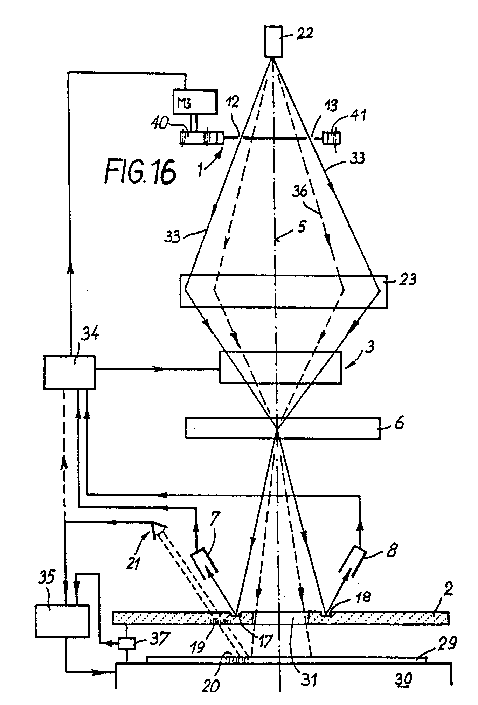

Fig. 16 zeigt eine mechanische Vorrichtung zum Drehen der Maskenstruktur gegenüber dem Wafer 29 zur ϑ-Korrektur. Die Einrichtung dreht dabei die Maske 1 über ein Getriebe, das in der beispielhaften Ausführungsform als Zahnradgetriebe 40, 41 ausgebildet ist, dessen Ritzel 40 von einem Motor M3 betätigt wird, der von der Steuereinrichtung 34 für den Multipol 3 und für die winkelmäßige Korrektur ϑ ansteuerbar ist.

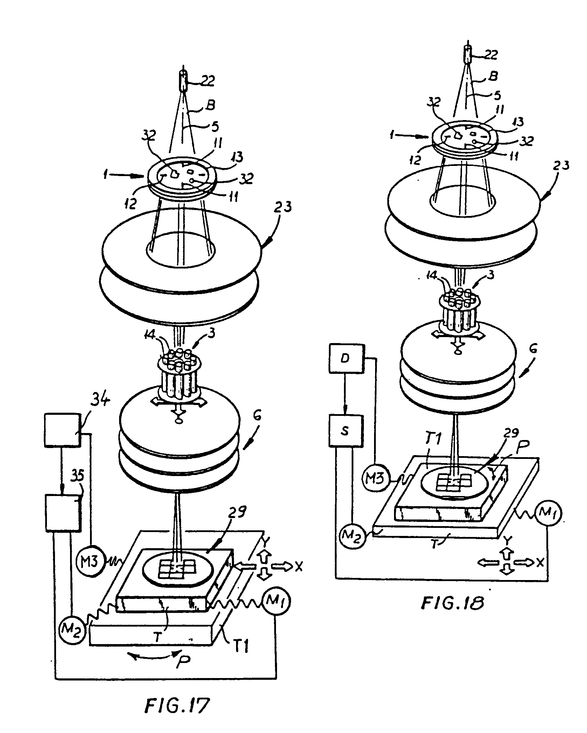

Gemäß den Fig. 17 und 18 ist ein Drehtisch T1 für die Ausführung der winkelmäßigen Korrektur ϑ (Drehen des Bildes der Maskenstruktur) vorgesehen. Der Drehtisch T1 kann dabei durch einen Motor M3 in Richtung des Doppelpfeiles P geschwenkte werden,je nach dem von der Steuereinrichtung 34 erhaltenenen Signal. In der Ausführungsform nach Fig. 17 trägt der Drehtisch T1 den Koordinatentisch T, wogegen gemäß Fig. 18 der Drehtisch T1 auf dem Koordinatentisch T gelagert ist.

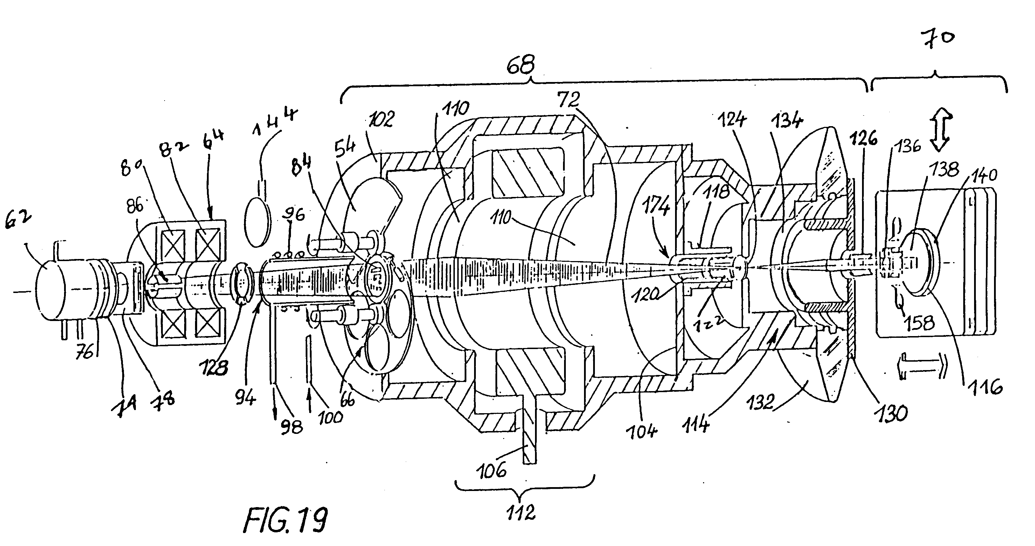

In Fig. 19 ist eine bevorzugte Ausgestaltung einer Ionenprojektionslithographiemaschine dargestellt. Die Hauptkomponenten sind aufeinanderfolgend : Die Ionenquelle 62, ein Solenoid 64, eine Maskenbaugruppe 66, die optische Säule 68 und die Projektionskammer 70. Ionen, die in der Ionenquelle 62 erzeugt werden, werden durch ein zwei Spulen aufweisendes Solenoid hindurchgeleitet, welches dazu dient, den Ionenstrahl zu analysieren und die gewünschte Ionenart abzutrennen, in der bevorzugten Ausführungsform sind das Heliumionen, welche von anderen im Ionenstrahl enthaltenen Ionenarten, wie sie aus der Ionenquelle austreten, separiert werden. Die Ionenquelle weist weiters eine Extraktionselektrode 74 auf,die bezüglich der Ionenquel le am negativen Potential liegt, um die in der Ionenquelle erzeugten Ionen zu beschleunigen. Weiters ist eine hinsichtlich des Potentials der Ionenquelle ebenfalls negatives Potential aufweisende Schirmelektrode 76 vorgesehen, mittels welcher eine zusätzliche Spannung aufgebracht werden kann, um Elektronen zurückzustoßen und dadurch ihren Zufluß zur optischen Säule zu verhindern. Der Extraktionselektrode 74 ist ein Tisch 78 zum Ausrichten der Ionenquelle in X- und Y-Richtung nachgeschaltet. Dieser Tisch erlaubt eine Gleitbewegung der ganzen Ionenquelle, um eine genaue Ausrichtung der Ionenquelle auf die Achse der Säule 68 zu ermöglichen. Die beiden Spulen 80 und 82 des Solenoids 64 sind einander entgegengesetzt gewickelt,um in einander entgegengesetzte Richtungen drehende Magnetfelder zu erzeugen, die auf die Ionen einwirken und verhindern, daß der Strahl um seine Achse rotiert, als Ergebnis des Durchlaufens des Solenoids. Das Solenoid vermindert auch den Winkel, unter welchem der Strahl auf die Maskenbaugruppe 66 auftrifft. Durch die Verminderung des Winkels trifft der Strahl mit größerem Fluß auf die Maske 84 auf und dringt durch deren Öffnungen in die Säule ein. Diese Winkelverkleinerung ist auch deshalb von Bedeutung, da die Maske eine gewisse Stärke aufweist und die in ihr befindlichen Kanäle sehr eng sind. Eine Verkleinerung des Einfallswinkels vermindert auch die Schattenbildung, welche durch die Maskenstärke verursacht wird. In der ersten Spule 80 des Solenoids befindet sich auch ein elektrischer Shutter 86, der von einer Multipolanordnung gebildet wird. Der elektrische Shutter lenkt den Strahl von der Säulenachse ab, bedingt durch Dipolfelder, die im elektrischen Shutter gebildet werden. Dieser Multipol kann jedoch auch Quadrupolfelder erzeugen, um die Vergrößerung am Quellenstrahl in der X- und Y-Richtung, d.s. eine Ebene senkrecht zur Achse des Strahles, zu regulieren und dadurch elliptische Verzerrungen in der Quelle zu korrigieren.

Im Bereich des Solenoids ist auch ein Vakuumtrennventil 144 vorgesehen, welches es ermöglicht, die optische Säule 68 von der Quelle zu trennen, um die Quelle durch eine andere zu ersetzen oder zu reparieren. Ein Monitor 128 für die Dosis ist hinter dem Solenoid angeordnet. Der äußere Rand des Strahles trifft auf eine bekannte Fläche des Monitors 78 auf, und der induzierte Strom wird dabei gemessen. Auf diese Weise kann der Fluß des Strahles durch die Säule verfolgt und die notwendige Belichtungszeit für einen bekannten Resist (Photolack) bestimmt werden.

Nach Durchlaufen des Dosismonitors 128 setzt der Strahl seinen Weg zur Maskenbaugruppe 66 fort, die ein Set von zueinander komplementären Masken 84 auf einer drehbaren Scheibe aufweist. Es ist lediglich eine Maske 84 gezeigt. Jede Maske ist in einem Halter 89 angeordnet, der eine Drehung der Maskenstruktur abhängig von einer linearen Bewegung einer Stoßstange 90 ermöglicht, die von einem piezoelektrischen Wandler 92 betätigt wird. Die Drehung der Maske 84 und damit auch die Drehung der Maskenstruktur in der Größenordnung von ± 500 Mikrorad wird abhängig von einem Alignmentsystem, für den Ionenstrahl gesteuert, was später noch beschrieben wird. Vor der Maskenbaugruppe 66 ist ein Belichtungsshutter 54 und ein Maskenkühlzylinder 94 angeordnet. Der Zylinder 94 erstreckt sich um die Achse des Strahles und wird durch ein Kühlmittel gekühlt, welches durch konzentrische Windungen 96 zirkuliert. Durch Strahlung kühlt der Zylinder 94 auch die Maske. Sobald der Shutter 54 sich in einer Stellung befindet, in welcher er den Strahl gegenüber der Maske abdeckt, verhindert er gleichzeitig auch eine Strahlungskühlung durch den Zylinder 94.

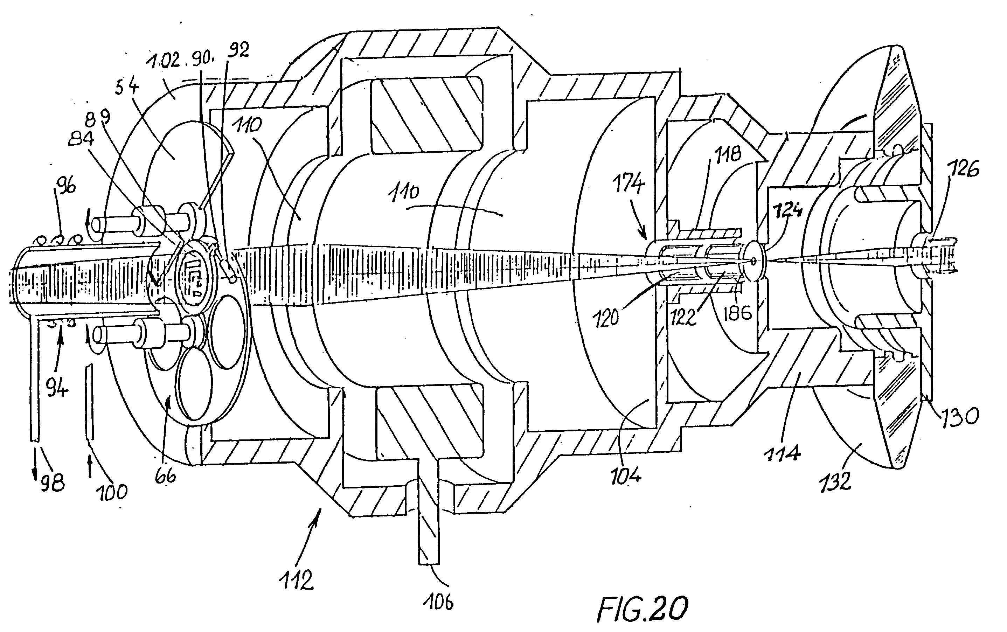

Aus den Fig. 19 und 20 ist ersichtlich, daß der Strahl, dessen Winkel geringfügig durch das Solenoid geändert wird, durch die Maske 84 hindurchtritt und eine beschleunigende Einzellinse 112 von großem Durchmesser erreicht. Die Einzellinse besitzt drei Elektroden. In der dargestellten Ausführung sind die erste Elektrode 102 und die dritte Elektrode 104 einstückig mit einem die Säule umschließenden Körper ausgebildet, der aus Metall besteht. Die beiden Elektroden befinden sich auf gleichem Potential. Die zweite oder Mittenelektrode 106 weist demgegenüber unterschiedliches, die Ionen beschleunigendes Potential auf. Ein Paar von Feldsteuerblenden 110 sind an jeder Seite der Mittelelektrode 106 angeordnet, um deren elektrisches Feld zu beschneiden und dadurch Verzerrungen zu vermeiden, welche in bekannter Weise durch solche Felder verursacht werden können.

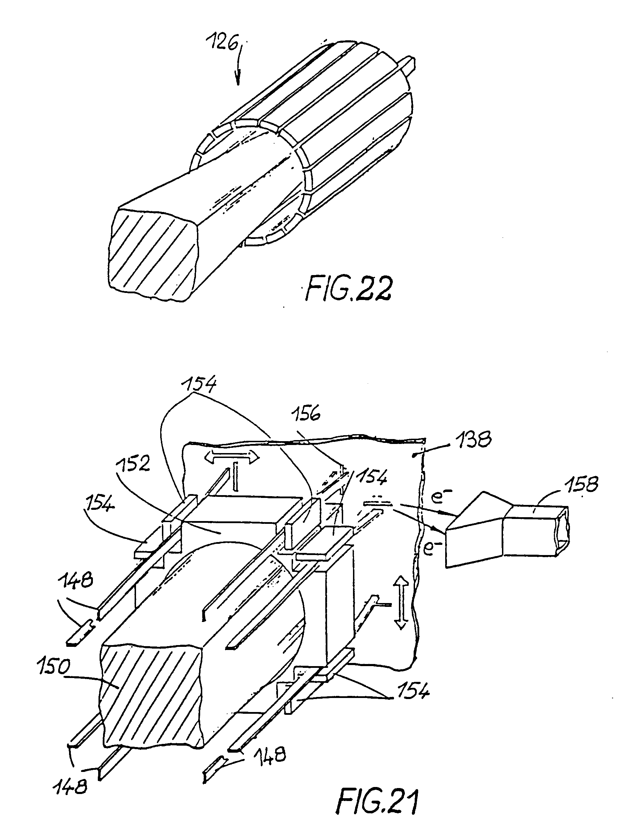

Der Verlauf des Strahles wird durch die Einzellinse geändert, sodaß der Strahl konvergiert und eine Kreuzungsstelle oder eine Abbildung der Ionenquelle zwischen der Einzellinse 112 und einer zweiten Immersions linse 114 einer sogenannten Gap-Linse bildet, die ihrerseits dazu dient, Ionen zu beschleunigen und ein Bild der Maskenstruktur auf dem Projektionstisch 116 zu bilden. Die Immersionslinse 114 ist in bekannter Weise eine aus zwei Elektroden bestehende Linse, wobei die beiden Elektroden an unterschiedlichen Potentialen liegen. Im dargestellten Ausführungsbeispiel ist die erste Elektrode 118 der Immersionslinse Bestandteil des starren Körpers, und die zweite Elektrode 130 ist von einer Isolierscheibe 132 am Ende des starren Hüllkörpers getragen. Wie sich aus dem schematisch dargestellten Verlauf des Strahles ergibt, bildet die Immersionslinse 114 Ionenstrahlen, die im wesentlichen parallel zur Achse der Säule sich fortbewegen. Eine Anordnung derartiger Ionenstrahlen wird als telezentrisch bezeichnet. Nahe der Stelle, wo die Einzellinse 112 eine Kreuzungsstelle des Ionenstrahles bildet, befindet sich eine Multipolbaugruppe 174, die bevorzugt aus zwei aufeinanderfolgenden Multipolen 120 und 122 besteht, welche durch Aufbringen eines geeigneten Dipolfeldes die Stellung des Strahles in der X-,Y-Ebene, d.h. der Bildebene, ändern. Durch Anwendung eines Dipolfeldes, dessen Stärke gleich, jedoch entgegengerichtet zu den Multipolen ist, kann der Strahl aus seiner ursprünglichen Bahn abgelenkt werden, verbleibt jedoch parallel zur Bahn. Die Größe dieser Ablenkung wird durch das Alignmentsystem für den Strahl gesteuert, abhängig von Signalen, welche von den Alignmentstrahlen erzeugt werden und beispielsweise ± 5 »m betragen können. Die Multipole weisen bevorzugt 16 Bogenstücke auf, wie diese aus Fig. 22 ersichtlich sind, welche genauer eine Zylinderfläche annähern als herkömmliche Stifte und die dazu verwendet werden können, jegliches Feld mit einer regelmäßigen Stärke, z.B. ein Dipol-, Quadrupol-, Oktopolfeld bis zu einem Sechzehnpolfeld zu erzeugen. In der praktischen Verwendung des dargestellten Ausführungsbeispieles werden die Felder höherer Ordnung vorher festgelegt, um Systemverzerrungen zu korrigieren, wogegen die Dipolfelder für die Ablenkung überlagert werden.

Der Multipolbaugruppe 174 folgt unmittelbar die Massentrennblende 124, welche in Verbindung mit dem Solenoid dazu dient, Ionen einer gewünschten Masse auszuwählen. In einer feldfreien Region abwärts der Blende 124 und der Immersionslinse 114 ist eine Multipol Baugruppe 126 zur Erzeugung von Quadrupolfeldern vorgesehen, um die relative Vergrößerung des Bildes in der X(M_{X})- und in der Y(M_{Y})-Richtung in der Waferebene im voneinander entgegengesetzten Sinn zu verändern. Wenn beispielsweise die Vergrößerung in der X-Richtung kleiner ausgeführt wird, dann wird die Vergrößerung in der Y-Richtung größer. Dieses Element wird daher zum Ausgleich von Maßstabsunterschieden zwischen X- und Y-Richtung eingesetzt, um Fehler zu kompensieren, die beispielsweise durch ein leichtes Kippen des Wafers in der Bildebene verursacht werden können. Für die absolute Anpassung der Vergrößerung wird die Spannung der Hauptlinse verwendet, wie noch später beschrieben wird. In der Ausführung gemäß Fig. 19 ist die Quadrupolbaugruppe 126 von sechzehn Bogen gebildet, wie dies in Fig. 22 dargestellt ist. Diese Baugruppe 126 wird von einem Alignmentsystem für den Projektionsstrahl abhängig von Signalen gesteuert, welche durch Sekundärelektronen erzeugt werden, die am Alignmentring (-block) oder am Wafer zerstreut werden, um Änderungen in den M_{X}- und M_{Y}-Werten mit einem Faktor von ungefähr ± 5 . 10⁻⁴ auszuführen. Selbstverständlich kann die unterschiedliche Steuerung des Maßstabes von M_{X} und M_{Y} durch Quadrupolfelder, welche einem Ionenprojektionslithographielinsensystem folgen, auch bei anderen Linsenkombinationen als den in Fig. 19 gezeigten, angewendet werden. In dieser Ausführungsform ist unmittelbar bevor der Strahl den Wafer trifft, ein Scanner für den Alignmentstrahl und ein Detektorensystem 136 angeordnet, welches dazu dient, die Lage des auf dem Wafer gebildeten Bildes anzuzeigen und ein Signal zu erzeugen, um Korrekturwirkungen der optischen Elemente entsprechend dem Alignmentfehler, der detektiert wird, in die Wege zu leiten.

In Fig.21 ist die Ausführung des Scanner- und Detektorsystems 136 für den Strahl mehr detailliert dargestellt. Die Teilstrahlen 148 sind vom Hauptfeld 150 im Scannersystem 136 dadurch getrennt, daß die Teilstrahlen durch die Außenseite eines Isolierteiles 152 hindurchtreten, wogegen das Hauptfeld 150 durch die Mitte des Isolierteiles 152 verläuft. An dieser Stelle werden die Teilstrahlen getrennt vom Hauptfeld gescannt dadurch, daß Dipolfelder zur Anwendung kommen, die auf der Scannerplatte 154 erzeugt werden. Die Teilstrahlen werden über Bezugsmarken 156 auf einem Wafer 138 gescannt. Streuelektronen, die von der Auftreffstelle der Teilstrahlen auf den Marken zurückgeworfen werden, werden von einem Detektor 158 erfaßt, der als Channeltron oder elektronischer Vervielfacher ausgebildet sein kann. Obwohl nur ein einziger Detektor dargestellt ist, ist es selbstverständlich, daß ein Paar von Detektoren für jede Alignmentmarke derzeit verwendet wird. Die Signale der Detektoren werden dazu verwendet, um die Stellung des Hauptfeldes 150 am Wafer 138 zu erfassen. Abhängig von den Signalen werden Korrekturfelder durch die ionenoptischen Elemente zur Anwendung gebracht oder es wird die Drehung des Feldes durch Drehung der Maske 84 angepaßt.

Die Stellung des Ringes (Blockes) bezüglich des Wafers kann auf interferometrischem Weg angezeigt werden, und die Positionierung des Hauptfeldes kann in diesem Fall ausschließlich abhängig von den Alignmentmarken am Ring (Block) gemacht werden. In diesem Fall können die Strukturen auf den Wafer aufgebracht werden, ohne daß sich auf dem Wafer Alignmcntmarken befinden, und der Wafer kann einfach von einer Stellung in eine andere bewegt werden, um wiederholt Strukturen auf den Wafer aufzubringen, nach einem sogenannten "Blind Stepping"-Vorgang. Wenn die Stellung des Alignmentblocks genau bestimmt wird, kann der Alignment-Block auch beim Messen von Systemverzerrungen verwendet werden, wobei das System als Meßsystem arbeitet.

Gemäß Fig. 19 ist der Wafer 138 auf einem Tisch 140 angeordnet, der genaue Bewegungen in X- und Y- (in der Waferebene) und in Z-Richtung (entlang der optischen Achse) erlaubt, sodaß der Wafer von einer Stellung in eine andere schrittweise bewegt werden kann und Bildwiederholungen an unterschiedlichen Stellen des Wafers vorgenommen werden können. Weiters kann auch die Lage des Wafers entlang der optischen Achse justiert werden.

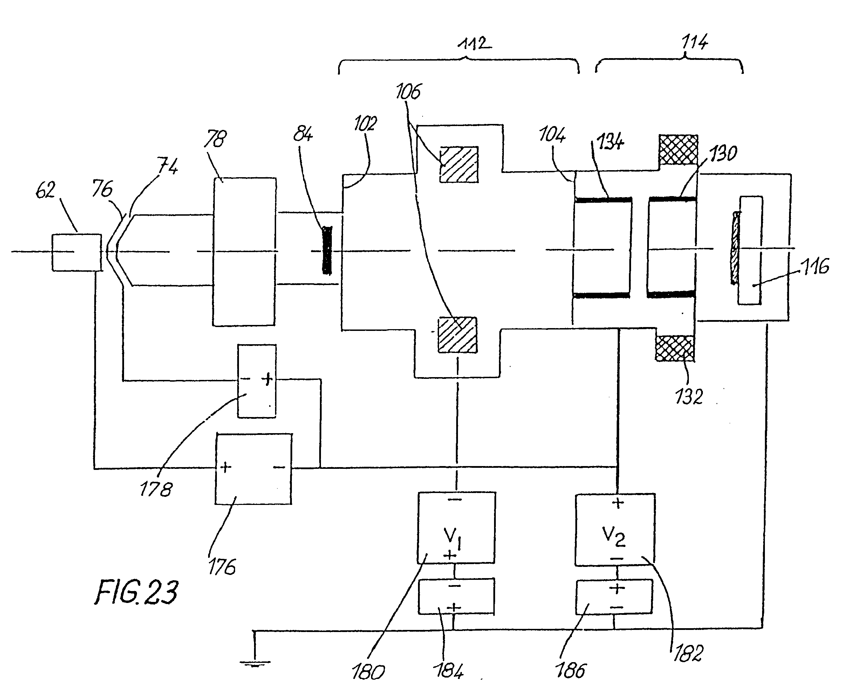

Aus Fig. 23 ist in Form eines Blockdiagramms die elektrische Versorgung der in Fig. 19 dargestellten Ausführungsform einer ionenoptischen Lithographieeinrichtung ersichtlich. Die Quelle 62 wird auf einem positiven Potential bezüglich der Extraktionselektrode 78 gehalten mittels einer Spannungsquelle 176, mit welcher das Beschleunigungspotential der abgesaugten Ionen zwischen beispielsweise 0 bis 10 kv verändert werden kann. Die Schirmelektrode 76 ist an eine Spannungsquelle 178 angeschlossen, welche die Schirmelektrode 76 an einem negativen Potential bezüglich der Quelle hält, um Elektronen zurückzustoßen.

Eine erste Spannungsquelle 180 drückt der Mittenelektrode 106 der Einzellinse 112 ein negatives Potential in Bezug auf die erste Elektrode 102 und die dritte Elektrode 104 der Einzellinse auf. Die Nettoenergie der Ionen wird dadurch durch diese Linse nicht beeinträchtigt. Die erste Elektrode 102 und die dritte Elektrode 104 der Einzellinse und die erste Elektrode der Immersionslinse 134 sind integrale Komponenten des starren Hüllkörpers der Ionensäule und erhalten ein positives Potential aus einer zweiten Spannungsversorgung 182. Die Immersionslinse wird mit Spannung aus der Quelle 182 versorgt, wobei der negative Anschluß der Spannungsquelle 182 mit der zweiten Elektrode 130 der Immersionslinse verbunden ist, wobei die zweite Elektrode 130 von der Säule durch einen Isolator 132 getrennt ist. Die Immersionslinse beschleunigt daher die positiven Ionen, bevor sie die Säule verlassen.

Die Brennweiten der elektrostatischen Linse sind abhängig von den Potentialdifferenzen zwischen ihren Elektroden und daher kann die Vergrößerung eines Bildes hinter den Linsen verändert werden. In der bevorzugten Ausführungsform der Fig. 19 , welche eine Anordnung mit zwei Linsen zeigt, ist die Vergrößerung des Bildes in der Bildebene 116 gleich dem Verhältnis der Brennweite der zweiten Linse zur Brennweite der ersten Linse, oder dem Verhältnis der Spannungsverhältnisse an jeder Linse, nämlich V₁/V₂. Durch Wahl der Spannungsverhältnisse der ersten und zweiten Linse kann die Grobvergrößerung gewählt werden. Wenn die an den Linsen angelegten Spannungsverhältnisse proportional erhöht werden, steigen auch proportional die Brennweiten, jedoch ändert sich die Vergrößerung nicht. Diese Justierung kann jedoch die Verzerrungen der beiden Linsen beeinflussen, wie dies noch später beschrieben wird. Die Änderung der Linsenspannung stellt daher ein genaues Mittel zur Feinabstimmung von Verzerrung und Vergrößerung dar. Für diese Feinabstimmung sind die Spannungsquellen 180 und 182 mit Ergänzungsquellen 184 und 186 versehen,die bevorzugt durch Computer gesteuert werden und abhängig von Signalen, die von den Alignmentstrahlen erzeugt werden, gesteuert werden, um die Linsenspannungen um wenige Prozent zu verändern.

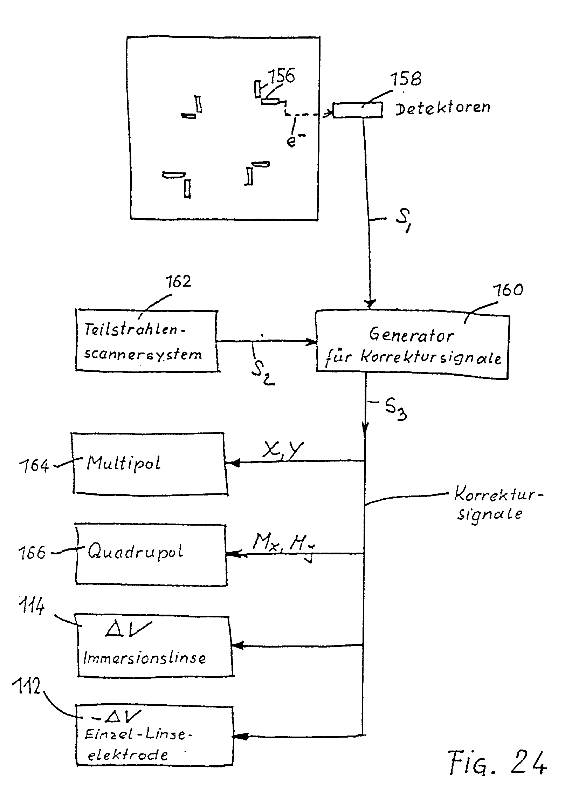

Fig. 24 zeigt ein Blockdiagramm des Alignmentsystems. Sekundärelektronen, die an den Alignmentmarken 156, die sich am Wafer und/oder am Alignmentblock, wie bereits erwähnt, befinden können, emittiert werden, werden durch Detektoren 158 erfaßt, die oberhalb der Marken angeordnet sind. Signale S1, die von den Detektoren erzeugt werden, werden einem Generator 160 für Korrektursignale zugeleitet. Der Signalgenerator 160 emfängt auch Signale S2 vom Scannersystem 162 für die Teilstrahlen. Diese Signale sind für die Scannposition der Teilstrahlen maßgebend, die durch die Scannerplatte 154, die in Fig. 21 dargestellt ist, gescannt werden. Der Signalgenerator 160 zeigt eine Abweichung im Alignment des Hauptfeldes durch Verarbeitung der Signale S1 und S2 an und erzeugt ein entsprechendes Korrektursignal S3, welches seinerseits den Steuergliedern für die verschiedenen Bildkorrekturelemente zugeleitet wird, um eine entsprechende Korrekturbewegung auszuführen, damit das Hauptfeld in die richtige Lage kommt. Unter den Steuereinrichtungen für die Korrektur befindet sich die Steuereinrichtung für den Multipol 164 zur Steuerung der Bewegung in X- und Y-Richtung, der Quadrupol 166 für Maßstabsänderungen M_{X} und M_{Y}, weiters die Ergänzungsspannungsquellen für die Immersions linse 114 und die Mittelelektrode der Einzellinse 112 zur Korrektur der Vergrößerung, und das Steuerelement für die Einrichtung zum Drehen der Maske (Umsetzer 172). Verschiedene Änderungen und Variationen der Erfindung sind im Lichte der vorstehenden Darlegungen möglich. Der Umrang der Erfindung ist daher nicht auf jene Details beschränkt, die vorstehend beschrieben sind, sondern kann auch in anderer Weise ausgeführt werden.

## Patentansprüche

1. Anordnung für die Ionenprojektionslithographie, mit einer Ionenprojektionseinrichtung und einem mit Markierungen (16-18) versehenen Träger, zum Positionieren der Abbildung der auf einer Maske (1) befindlichen Strukturen (32) auf einen Wafer (29) wobei für das Alignment Abbildungen der Markierungen (11 - 13) der Maske (1) durch Beeinflussung eines Referenzstrahles auf dem Träger in Koinzidenz mit den auf dem Träger vorhandenen, jeweils korrespondierenden Markierungen (16 - 18) gebracht werden, wobei die Ionenprojektionseinrichtung im Strahlengang einen elektrostatischen, durch eine Steuereinrichtung (34) beeinflußbaren Multi-, insbes. Oktopol (3) sowie eine Einrichtung (4) zur Drehung des Bildes der Maskenstruktur (32) um die ionenoptische Achse sowie eine Einrichtung zur Korrektur des Abbildungsmaßstabes enthält, wobei Detektoren (7 - 10) für von den Markierungen (16 - 18) ausgehende Sekundärstrahlung, insbes. Sekundärelektronen, die von den durch die Maskenmarkierungen (11 - 13) hindurchtretenden Referenzstrahlen (33) herrühren, vorgesehen sind, und die Signale der Detektoren (7 - 10) der Steuereinrichtung (34) für den Multi- insbes. Oktopol (3) und der Einrichtung zur Drehung des Bildes der Maskenstruktur sowie der Einrichtung zur Maßstabskorrektur zuführbar sind, dadurch gekennzeichnet, daß der mit den Markierungen (16 - 18) versehene Träger ein in vorgegebener Position relativ zum Wafer (29), jedoch örtlich getrennt vom Wafer (29), bevorzugt parallel zum Wafer, in Strahlrichtung vor dem Wafer (29) angeordneter Referenzblock (2) ist, der eine Öffnung (31) aufweist, die der Größe der auf dem Wafer (29) entstehenden Masken-Abbildung entspricht, so daß die Markierungen (16 - 18) außerhalb des Strahlenganges der das Bild auf dem Wafer (29) erzeugenden Ionenprojektionseinrichtung angeordnet sind, daß die Detektoren (7 - 10) zur Aufnahme der von den Markierungen (16 - 18) am Referenzblock emittierten Sekundärstrahlung angeordnet sind und daß die Einrichtung zur Maßstabskorrektur bei der 1 : 1 Schattenprojektion als mechanische Einrichtung zur Änderung der Höhenlage des Wafers (29) ausgebildet ist.

2. Anordnung nach Anspruch 1, dadurch gekennzeichnet, daß zur Positionierung des Wafers (29) relativ zum Referenzblock (2), der Referenzblock (2) mit weiteren Markierungen (19), z.B. in Form eines Strichgitters, versehen ist, und daß am Wafer (29) mit den am Referenzblock (2) vorgesehenen zusätzlichen Markierungen (19) korrespondierende Markierungen (20) vorgesehen sind, wobei zur Feststellung von Abweichungen in der Lageübereinstimmung der am Referenzblock (2) und am Wafer (29) befindlichen Markierungen (19, 20), eine optische Alignment-Einrichtung (21) vorgesehen ist.

3. Anordnung nach Anspruch 2, dadurch gekennzeichnet, daß die zur Feststellung von Abweichungen in der Lageübereinstimmung der Strichmarkierungen (19,20) vorgesehene optische Einrichtung (21) mit einer Steuereinrichtung (35) für die Bewegung eines Tisches (30), auf dem der Wafer (29) befestigt ist, gekuppelt ist, wobei Signale der optischen Einrichtung (21) der Steuereinrichtung (35) für die Tischbewegung zuführbar sind.

4. Anordnung nach Anspruch 2, dadurch gekennzeichnet, daß die optische Einrichtung (21) zur Feststellung von Abweichungen in der Lageübereinstimmung der Strichmarkierungen (19,20) mit der Steuereinrichtung (34) für den Multipol (3) und der Einrichtung zur Drehung des Bildes der Maskenstruktur gekuppelt ist.

5. Anordnung nach Anspruch 3, dadurch gekennzeichnet, daß zum Feststellen von Lageänderungen des Wafers (29) gegenüber dem Referenzblock (2) ein Interferometer (37), insbes. ein Laserinterferometer, vorgesehen ist, wobei Steuereinrichtungen (35) des Tisches (30) vom Interferometer (37) ansteuerbar sind.

6. Anordnung nach einem der Ansprüche 1 bis 5, dadurch gekennzeichnet, daß im Strahlengang ausschließlich der Referenzstrahlen (33) Ablenkeinheiten (38), z.B. Oktopole, die als elektrisches Dipolfeld geschaltet sind, angeordnet sind.

7. Anordnung nach einem der Ansprüche 1 bis 6, dadurch gekennzeichnet, daß die Einrichtung zur Drehung des Bildes der Maskenstruktur als Einrichtung (4) zur Erzeugung eines magnetischen, axialen Feldes ausgebildet ist.

8. Anordnung nach einem der Ansprüche 1 bis 6, dadurch gekennzeichnet, daß die Einrichtung zur Drehung des Bildes der Maskenstruktur als durch einen Motor (M3) betätigbares Getriebe (40, 41) zum Drehen der Maske (1) ausgebildet ist.

9. Anordnung nach einem der Ansprüche 1 bis 6, dadurch gekennzeichnet, daß die Einrichtung zur Drehung des Bildes der Maskenstruktur als Drehtisch (T1) ausgebildet ist, der den Wafer (29) trägt und durch einen steuerbaren Motor (M3) betätigbar ist.

10. Anordnung nach Anspruch 9, dadurch gekennzeichnet, daß der Motor (M3) für die Betätigung des Drehtisches (T1) von der Steuereinrichtung (34) für das Alignment in X-Richtung, Y-Richtung und Drehung (Θ) ansteuerbar ist.

11. Anordnung nach Anspruch 9 oder 10, dadurch gekennzeichnet, daß der Drehtisch (T1) den Koordinatentisch (T) trägt (Fig. 17) oder auf dem Koordinatentisch (T) angeordnet ist (Fig. 18).

12. Alignmentverfahren unter Verwendung einer Anordnung nach Anspruch 3 oder nach Anspruch 3 in Verbindung mit einem der Ansprüche 6 bis 11, dadurch gekennzeichnet, daß durch Beeinflussung der Ionenprojektionseinrichtung während des Alignmentvorganges die Bilder der Markierungen der Maske in Übereinstimmung mit den zugeordneten Markierungen auf dem Referenzblock gehalten werden und optisch festgestellte Abweichungen in der Lageübereinstimmung der am Referenzblock vorgesehenen weiteren Markierungen gegenüber den ihnen zugeordneten Markierungen am Wafer, durch Verschiebung des Tisches (30) gegenüber dem Referenzblock kompensiert werden, wobei entweder a) der Fehler der Lageübereinstimmung zwischen den am Referenzblock vorgesehenen weiteren Markierungen gegenüber den ihnen zugeordneten Markierungen am Wafer laufend während der Belichtung detektiert und in eine solche Korrekturbewegung des Tisches umgesetzt wird, daß ein Unterschreiten eines Schwellenwertes des Fehlers erfolgt, oder b) die Lageübereinstimmung zwischen den am Referenzblock vorgesehenen weiteren Markierungen gegenüber den ihnen zugeordneten Markierungen am Wafer über das optische Alignment-System vor der Belichtung herbeigeführt wird.

13. Alignmentverfahren unter Verwendung einer Anordnung nach Anspruch 5 oder nach Anspruch 5 in Verbindung mit einem der Ansprüche 6 bis 11, dadurch gekennzeichnet, daß durch Beeinflussung der Ionenprojektionseinrichtung während des Alignmentvorganges die Bilder der Markierungen der Maske in Übereinstimmung mit den zugeordneten Markierungen auf dem Referenzblock gehalten werden, wobei zunächst der Tisch (30) in eine Lage gebracht wird, in der die Markierungen auf dem Wafer lediglich um weniger als ein vorgegebenes Maß, z.B. um weniger als 1 »m, von der Sollage gegenüber den ihnen zugeordneten, weiteren Markierungen des Referenzblockes abweichen, wonach das Interferometer aktiviert und zumindest bis zur Beendigung der Belichtung in aktivem Zustand gehalten wird und daß nach Aktivierung des Interferometers, die optisch festgestellten Abweichungen in der Lageübereinstimmung der am Referenzblock vorgesehenen weiteren Markierungen gegenüber den ihnen zugeordneten Markierungen am Wafer, ionenoptisch korrigiert werden, wobei entsprechend einem vorgegebenen Zusammenhang zwischen der optisch festgestellten Abweichung und den Einwirkgrößen auf die Ionenprojektionseinrichtung zur Korrektur dieser Abweichung, auf die Ionenprojektionseinrichtung eingewirkt wird, wonach eine Belichtung erfolgt.

14. Alignmentverfahren nach Anspruch 13, dadurch gekennzeichnet, daß der Belichtung mindestens eine weitere Belichtung folgt, um ein und denselben Chip unter Verwendung derselben Maske in mindestens einer weiteren Stufe zu belichten, wobei zwischen zwei aufeinanderfolgenden Belichtungen zunächst die Abbildung der Markierungen der Maske auf die Markierungen des Referenzblockes ausgerichtet werden, wonach die Detektoren in den inaktiven Zustand versetzt werden und die ionenoptische Einrichtung nunmehr abhängig von der optisch festgestellten Abweichung der zusätzlichen Markierungen des Referenzblockes von den zugeordneten Markierungen am Wafer korrigiert wird, wonach wieder eine Belichtung erfolgt.

15. Alignmentverfahren nach Anspruch 14, dadurch gekennzeichnet, daß anschließend an das Versetzen des Stabilisierungssystems für die Abbildung der Markierungen der Maske auf die zugeordneten Markierungen des Referenzblockes in den inaktiven Zustand, bis zum Ende der Belichtung, die ionenoptische Einrichtung abhängig von der optisch festgestellten Lageabweichung der zusätzlichen Markierungen am Referenzblock von den Markierungen am Wafer, korrigiert wird.

16. Alignmentverfahren unter Verwendung einer Anordnung nach Anspruch 6 oder nach Anspruch 6 in Verbindung mit einem der Ansprüche 7 bis 11, bei Fixierung des Referenzblockes nach einem Verfahren gemäß Anspruch 12 oder 13, dadurch gekennzeichnet, daß ausschließlich die Referenzstrahlen dem Einfluß eines zeitlich veränderbaren Feldes unterworfen und dadurch über einen, die den Markierungen der Maske zugeordneten Markierungen enthaltenden, Bereich des Referenzblockes, bevorzugt mit konstanter Geschwindigkeit, hin- und herbewegt werden, wobei beim Überstreichen einer Markierung, z.B. Grube, der Detektor ein maximales Signal liefert, dem ein bestimmter Augenblickswert der zeitlich sich ändernden Ablenkspannung für die Referenzstrahlen zugeordnet ist, daß dieser Augenblickswert mit einem Sollspannungswert verglichen wird, der dem maximalen Detektorsignal bei stabilisiertem, d.h. sich gegenüber dem Referenzblock nicht bewegenden Bild der Maskenstruktur, entspricht, wenn hierbei die Referenzstrahlen eine Markierung des Referenzblockes überstreichen, und daß der Unterschied zwischen dem Augenblickswert der Ablenkspannung und dem Sollspannungswert durch Beeinflussung des ionenoptischen Abbildungssystems kompensiert wird.

## Claims

1. An arrangement for ion projection lithography, comprising an ion projection means and a support provided with markings (16 - 18) for positioning the image of structures (32) on a mask (1) on to a wafer (29), wherein for alignment purposes images of the markings (11 - 13) of the mask (1) on the support are brought into coincidence with respectively corresponding markings (16 - 18) on the support, by influencing a reference ray, the ion projection means containing in the ray path an electrostatic multipole, more particularly an octopole (3), which can be influenced by a control means (34), and a means (4) for rotating the image of the mask structure (32) about the ion-optical axis, and means for correcting the imaging scale, detectors (7 - 10) being provided for secondary radiation from the markings (16 - 18), more particularly secondary electrons originating from the reference rays (33) passing through the mask markings (11 - 13), and the signals from the detectors (7 - 10) are adapted to be fed to the control means (34) for the multipole, more particularly octopole (3), and to the means for rotating the image of the mask structure and to the means for the scale correction, characterised in that the support provided with the markings (16 - 18) is a reference block (2) which is disposed in a preset position relatively to the wafer (29), but locally separate therefrom, preferably parallel thereto, in front of the wafer (29) as considered in the ray direction, said reference block having an aperture (31) corresponding to the size of the mask image forming on the wafer (29), so that the markings (16 - 18) are disposed outside the path of the rays of the ion projection means producing the image on the wafer (29), in that the detectors (7 - 10) are disposed to receive the secondary radiation emitted by the markings (16 - 18) on the reference block, and in that the scale correction means for 1 : 1 shadow projection is in the form of a mechanical means for changing the vertical position of the wafer (29).

2. An arrangement according to claim 1, characterised in that for the purpose of positioning the wafer (29) relatively to the reference block (2) the latter is provided with additional markings (19), e.g. in the form of a ruled grating, and in that markings (20) corresponding to the additional markings (19) on the reference block (2) are provided on the wafer (29), an optical alignment means (21) being provided to detect deviations in the positional coincidence of the markings (19, 20) on the reference block (2) and on the wafer (29).

3. An arrangement according to claim 2, characterised in that the optical means (21) provided for detecting deviations in the positional coincidence of the line markings (19, 20) is coupled to a control means (35) for the movement of a table (30) on which the wafer (29) is secured, signals from the optical means (21) being adapted to be fed to the control means (35) for the table movement.

4. An arrangement according to claim 2, characterised in that the optical means (21) for detecting deviations in the positional coincidence of the line markings (19, 20) is coupled to the control means (34) for the multipole (3) and to the means for rotating the image of the mask structure.

5. An arrangement according to claim 3, characterised in that an interferometer (37), more particularly a laser interferometer, is provided to detect changes in the position of the wafer (29) relative to the reference block (2), control means (35) for the table (30) being actuatable by the interferometer (37).

6. An arrangement according to any one of claims 1 to 5, characterised in that deflection units (38), e.g. octopoles, which are connected as an electrical dipole field, are disposed in the path of the rays exclusively of the reference rays (33).

7. An arrangement according to any one of claims 1 to 6, characterised in that the means for rotating the mask structure image are constructed as a means (4) for generating a magnetic axial field.

8. An arrangement according to any one of claims 1 to 6, characterised in that the means for rotating the mask structure image is constructed as a gear (40, 41) for rotating the mask (1), such gear being operable by a motor (M3).

9. An arrangement according to any one of claims 1 to 6, characterised in that the means for rotating the mask structure image is constructed as a turntable (T1) which carries the wafer (20) and is operable by a controllable motor (M3).

10. An arrangement according to claim 9, characterised in that the motor (M3) for operating the turntable (T1) is actuatable by the control means (34) for the alignment in the X-direction, Y-direction and rotation (Θ).

11. An arrangement according to claim 9 or 10, characterised in that the turntable (T1) carries the co-ordinates table (T) (Fig. 17) or is disposed on the co-ordinates table (T) (Fig. 18).

12. An alignment method using an arrangement according to claim 3 or according to claim 3 in conjunction with any one of claims 6 to 11, characterised in that the ion projection means is influenced during the alignment operation to keep the images of the markings of the mask in coincidence with the associated markings on the reference block and optically detected deviations in the positional coincidence of the other markings on the reference block relative to their associated markings on the wafer are compensated for by displacement of the table (30) relative to the reference block, wherein either (a) the error in the positional coincidence between the other markings on the reference block relative to their associated markings on the wafer is continuously detected during exposure and converted to a table correction movement such that there is an undershoot of the error threshold value, or (b) the positional coincidence between the other markings on the reference block relative to their associated markings on the wafer is produced by means of the optical alignment system before the exposure.

13. An alignment method using an arrangement according to claim 5 or according to claim 5 in conjunction with any one of claims 6 to 11, characterised in that the ion projection means is influenced during the alignment operation to keep the images of the markings of the mask in coincidence with the associated markings on the reference block, wherein initially the table (30) is brought into a position in which the markings on the wafer deviate from their associated other markings on the reference block only by less than a predetermined amount, e.g. by less than 1 »m, from the set-value position, whereafter the interferometer is activated and is kept in the active state at least until the termination of the exposure and in that after activation of the interferometer the optically detected deviations in the positional coincidence of the other markings on the reference block relative to their associated markings on the wafer are ion-optically corrected, the ion projection means being acted upon in accordance with a predetermined relationship between the optically detected deviation and the parameters for acting on the ion projection means to correct such deviation, whereafter exposure takes place.

14. An alignment method according to claim 13, characterised in that the exposure is followed by at least one other exposure in order to expose one and the same chip in at least one other stage using the same mask, wherein between two successive exposures the image of the markings on the mask is initially aligned to the markings on the reference block, whereafter the detectors are set to the inactive state and the ion-optical means is then corrected in dependence on the optically detected deviation of the additional markings on the reference block from their associated markings on the wafer, whereafter an exposure again takes place.

15. An alignment method according to claim 14, characterised in that subsequent to the stabilisation system for the imaging of the markings on the mask on to the associated markings on the reference block being set to the inactive state, until the end of exposure, the ion-optical means is corrected in dependence on the optically detected positional deviation of the additional markings on the reference block from the markings on the wafer.

16. An alignment method using an arrangement according to claim 6 or according to claim 6 in conjunction with any one of claims 7 to 11, the reference block being fixed by a method according to claim 12 or 13, characterised in that only the reference rays are subjected to the influence of a field variable per unit of time so that the same are reciprocated, preferably at a constant speed, over a reference block area containing the markings associated with the markings on the mask, wherein when a marking, e.g. a cavity, is swept, the detector delivers a maximum signal with which there is associated a specific instantaneous value of the reference ray deflection voltage varying per unit of time, in that said instantaneous value is compared with a voltage set-value corresponding to the maximum detector signal in the case of a stabilised mask structure image, i.e. a mask structure image which does not move relatively to the reference block, when the reference rays sweep a reference block marking, and in that the difference between the instantaneous value of the deflection voltage and the voltage set-value is compensated for by influencing the ion-optical imaging system.

## Revendications

1. Agencement pour la lithographie par projection d'ions, avec un dispositif de projection d'ions et un support pourvu de repères (16 - 18), pour positionner sur une galette de silicium (29) la projection des structures (32) qui se trouvent sur un masque (1), les projections de repères (11 - 13) du masque (1) sur le support étant, aux fins d'alignement, en agissant sur un faisceau de référence, amenées en coïncidence avec les repères respectivement correspondants (16 - 18) présents sur le support, le dispositif de projection d'ions contenant, dans la marche des rayons, un pôle multiple, notamment un octopôle (3) soumis à l'action d'un dispositif de commande (34), ainsi qu'un dispositif (4) pour faire tourner l'image des structures (32) du masque autour de l'axe opto-ionique, et qu'un dispositif pour corriger l'échelle de projection, des détecteurs (7 - 10) étant prévus pour le rayonnement secondaire provenant des repères (16 - 18), à savoir notamment les électrons secondaires qui proviennent des faisceaux de référence (33) passant par les repères (11 - 13) du masque, et les signaux des détecteurs (7 - 10) pouvant être transmis au dispositif de commande (34) pour le pôle multiple, notamment l'octopôle (3), ainsi qu'au dispositif pour faire tourner l'image des structures du masque et qu'au dispositif de correction d'échelle, **caractérisé** en ce que le support pourvu des repères (16 - 18) est un bloc de référence (2), qui est disposé dans une position prédéterminée par rapport à la galette (29), avant la galette (29) dans la direction du faisceau, de préférence parallèlement à la galette mais en un lieu séparé de la galette (29), et qui présente une ouverture (31) qui correspond à la taille de la projection du masque obtenue sur la galette (29), de sorte que les repères (16 - 18) sont disposés en dehors de la marche des rayons du dispositif de projection d'ions produisant l'image sur la galette (29), en ce que les détecteurs (7 - 10) sont disposés de façon à recevoir le rayonnement secondaire émis par les repères (16 - 18) du bloc de référence, et en ce que le dispositif de correction d'échelle à l'échelle de projection 1 : 1 est conçu comme dispositif mécanique pour modifier la position en hauteur de la galette (29).

2. Agencement selon la revendication 1, **caractérisé** en ce qu'afin de positionner la galette (29) par rapport au bloc de référence (2), le bloc de référence (2) est pourvu de repères supplémentaires (19), par exemple sous la forme d'un réseau de traits, et en ce que sont prévus sur la galette (29) des repères (20) correspondant aux repères supplémentaires (19) prévus sur le bloc de référence (2), un dispositif d'alignement optique (21) étant prévu pour déterminer les écarts de coïncidence de position des repères (19, 20) présents sur le bloc de référence (2) et la galette (29).

3. Agencement selon la revendication 2, **caractérisé** en ce que le dispositif optique (21) pour déterminer les écarts de coïncidence de position des traits de repère prévus (19, 20) est couplé à un dispositif de commande (35) pour le déplacement d'une table (30) sur laquelle est fixée la galette (29), les signaux du dispositif optique (21) pouvant être transmis au dispositif (35) de commande du déplacement de la table.

4. Agencement selon la revendication 3, **caractérisé** en ce que le dispositif optique (21) pour déterminer les écarts de coïncidence de position des traits de repère (19, 20) est couplé au dispositif de commande (34) pour le pôle multiple (3) et au dispositif pour faire tourner l'image des structures du masque.

5. Agencement selon la revendication 3, **caractérisé** en ce qu'un interféromètre (37), notamment un interféromètre laser, est prévu pour déterminer les modifications de position de la galette (29) par rapport au bloc de référence (2), des dispositifs (35) de commande de la table (30) pouvant être asservis par l'interféromètre (37).

6. Agencement selon l'une quelconque des revendications 1 à 5, **caractérisé** en ce que des unités de déflexion (38), par exemple des octopôles connectés en champ électrique dipolaire, sont disposées dans la marche des rayons des seuls faisceaux de référence (33).

7. Agencement selon l'une quelconque des revendications 1 à 6, **caractérisé** en ce que le dispositif pour faire tourner l'image des structures du masque est conçu comme dispositif (4) pour produire un champ magnétique axial.

8. Agencement selon l'une quelconque des revendications 1 à 6, **caractérisé** en ce que le dispositif pour faire tourner l'image des structures du masque est conçu comme mécanisme de transmission (40, 41) pour faire tourner le masque (1), mécanisme qui peut être actionné par un moteur (M3).

9. Agencement selon l'une quelconque des revendications 1 à 6, **caractérisé** en ce que le dispositif pour faire tourner l'image des structures du masque est conçu comme table tournante (T1), qui porte la galette (29) et peut être actionnée par un moteur asservissable (M3).

10. Agencement selon la revendication 9, **caractérisé** en ce que le moteur (M3) pour l'actionnement de la table tournante (T1) peut être asservi par le dispositif de commande (34) pour l'alignement dans la direction X et dans la direction Y et pour la rotation (ϑ).

11. Agencement selon la revendication 9 ou 10, **caractérisé** en ce que la table tournante (T1) porte la table de coordonnées (T) (figure 17), ou est disposée sur la table de coordonnées (T) (figure 18).

12. Procédé d'alignement en utilisant un agencement selon la revendication 3 ou selon la revendication 3 conjointement avec l'une quelconque des revendications 6 à 11, **caractérisé** en ce qu'en agissant sur le dispositif de projection d'ions pendant le processus d'alignement, les images des repères du masque sont maintenues en coïncidence avec les repères associés sur le bloc de référence, et les écarts optiquement déterminés de coïncidence de position des repères supplémentaires prévus sur le bloc de référence, par rapport aux repères qui leurs sont associés sur la galette, sont compensés en déplaçant en translation la table (30) par rapport au bloc de référence, et ce faisant, soit a) les erreurs de coïncidence de position entre les repères supplémentaires prévus sur le bloc de référence et les repères qui leur sont associés sur la galette sont détectées en continu pendant l'exposition et transformées en un déplacement correcteur de la table permettant de passer en dessous d'une valeur de seuil d'erreur, soit (b) la coïncidence de position entre les repères supplémentaires prévus sur le bloc de référence et les repères qui leur sont associés sur la galette est réalisée avant l'exposition au moyen du système d'alignement optique.

13. Procédé d'alignement en utilisant un agencement selon la revendication 5 ou selon la revendication 5 conjointement avec l'une quelconque des revendications 6 à 11, **caractérisé** en ce qu'en agissant sur le dispositif de projection d'ions pendant le processus d'alignement, les images des repères du masque sont maintenues en coïncidence avec les repères associés sur le bloc de référence, la table (30) étant tout d'abord amenée dans une position dans laquelle les repères sur la galette ne diffèrent que de moins d'une valeur prédéterminée, par exemple moins de 1 »m, de leur position de consigne par rapport aux repères supplémentaires du bloc de référence qui leur sont associés, à la suite de quoi l'interféromètre est activé et maintenu à l'état actif au moins jusqu'à l'achèvement de l'exposition, et en ce qu'à la suite de l'activation de l'interféromètre, les écarts optiquement déterminés de coïncidence de position des repères supplémentaires prévus sur le bloc de référence, par rapport aux repères qui leurs sont associés sur la galette, sont corrigés de façon opto-ionique, en agissant sur le dispositif de projection d'ions, afin de corriger l'écart optiquement déterminé, conformément à une relation prédéterminée entre cet écart et les variables d'action sur le dispositif de projection d'ions, l'exposition étant effectuée à la suite de cette action.

14. Procédé d'alignement selon la revendication 13, **carac****térisé** en ce que l'exposition est suivie d'au moins une autre exposition, afin de soumettre une seule et même pastille à au moins une étape d'exposition supplémentaire en utilisant le même masque, et ce faisant, entre deux expositions successives, les projections des repères du masque sont alignées sur les repères du bloc de référence, à la suite de quoi les détecteurs sont désactivés et le dispositif opto-ionique est maintenant corrigé en fonction de l'écart optiquement déterminé des repères supplémentaires du bloc de référence par rapport aux repères associés sur la galette, à la suite de quoi une nouvelle exposition est effectuée.

15. Procédé d'alignement selon la revendication 14, **carac****térisé** en ce qu'à la suite de la désactivation du réglage du système de stabilisation pour la projection des repères du masque sur les repères associés du bloc de référence, le dispositif opto-ionique est, jusqu'à la fin de l'exposition, corrigé en fonction de l'écart optiquement déterminé des repères supplémentaires du bloc de référence par rapport aux repères sur la galette.

16. Procédé d'alignement en utilisant un agencement selon la revendication 6 ou selon la revendication 6 conjointement avec l'une quelconque des revendications 7 à 11, avec fixation en position du bloc de référence par un procédé selon la revendication 12 ou 13, **caractérisé** en ce que les seuls faisceaux de référence sont soumis à l'influence d'un champ modifiable dans le temps et sont ainsi déplacés en va-et-vient, de préférence à vitesse constante, sur une zone du bloc de référence contenant les repères associés aux repères du masque, et ce faisant, lors du balayage d'un repère, par exemple d'un creux, le détecteur délivre un signal maximal auquel est associée une valeur momentanée déterminée de la tension de déflexion, variable dans le temps, pour les faisceaux de référence, en ce que cette valeur momentanée est comparée à une valeur de tension de consigne qui correspond au signal maximal du détecteur pour une image stabilisée des structures du masque, c'est-à-dire ne bougeant pas par rapport au bloc de référence, lorsque les faisceaux de référence balayent un repère du bloc de référence, et en ce que la différence entre la valeur momentanée de la tension de déflexion et la valeur de tension de consigne est compensée en agissant sur le système de projection opto-ionique.
